(19)

Europäisches
Patentamt
European
Patent Office
Office européen
des brevets

(11)     **EP 1 869 667 B1**

(12)     **EUROPEAN PATENT SPECIFICATION**

(45) Date of publication and mention
of the grant of the patent:
**08.05.2019  Bulletin 2019/19**

(21) Application number: **06706552.4**

(22) Date of filing: **01.02.2006**

(51) Int Cl.:
$G10L\ 19/008$ (2013.01)     $H04S\ 3/00$ (2006.01)

(86) International application number:
**PCT/EP2006/000875**

(87) International publication number:
**WO 2006/108462 (19.10.2006 Gazette 2006/42)**

(54) **MULTI-CHANNEL HIERARCHICAL AUDIO CODING WITH COMPACT SIDE-INFORMATION**

HIERARCHISCHE MEHRKANALTONKODIERUNG MIT KOMPAKTER SEITENINFORMATION

CODAGE AUDIO HIERARCHIQUE MULTICANAUX EFFECTUE AVEC DES INFORMATIONS
ANNEXES COMPACTES

(84) Designated Contracting States:
**AT BE BG CH CY CZ DE DK EE ES FI FR GB GR
HU IE IS IT LI LT LU LV MC NL PL PT RO SE SI
SK TR**

(30) Priority: **21.12.2005  US 314711
15.04.2005  US 671544 P**

(43) Date of publication of application:
**26.12.2007   Bulletin 2007/52**

(73) Proprietors:
• **Fraunhofer-Gesellschaft zur Förderung der
angewandten Forschung e.V.
80686 München (DE)**
• **Dolby International AB
1101 CN  Amsterdam Zuid-Oost (NL)**
• **Koninklijke Philips N.V.
5656 AE Eindhoven (NL)**

(72) Inventors:
• **HOELZER, Andreas
91054 Erlangen (DE)**
• **HERRE, Juergen
91054 Buckenhof (DE)**
• **ROEDEN, Jonas
S-16955 Solna (SE)**
• **PURNHAGEN, Heiko
S-17265 Sundbyberg (SE)**
• **KJOERLING, Kristofer
S-17075 Solna (SE)**
• **ENGDEGARD, Jonas
S-11543 Stockholm (SE)**

• **BREEBAART, Jeroen,
Koninklijke Philips Elec. N.V.
NL-5621 Eindhoven (NL)**
• **SCHUIJERS, Erik,
Koninklijke Philips Elec. N.V.
NL-5621 Eindhoven (NL)**
• **OOMEN, Werner,
Koninklijke Philips Elec. N.V.
NL-5621 Eindhoven (NL)**
• **VILLEMOES, Lars
S-17556 Jaerfaella (SE)**

(74) Representative: **Zinkler, Franz et al
Schoppe, Zimmermann, Stöckeler
Zinkler, Schenk & Partner mbB
Patentanwälte
Radlkoferstrasse 2
81373 München (DE)**

(56) References cited:
**WO-A-2005/101370     WO-A1-2006/072270
US-A1- 2003 219 130     US-A1- 2005 074 127**

• **BREEBART J, HERRE J, FALLER C, RÖDÉN J,
MYBURG F, DISCH S, PURNHAGEN H, HOTHO G,
NEUSINGER M, KJÖRLING K, OOMEN W: "MPEG
Spatial Audio Coding / MPEG surround: Overview
and Current Status" 119TH AUDIO ENGINEERING
SOCIETY CONVENTION, 7 October 2005
(2005-10-07), pages 1-17, XP002379094 New York,
USA**

**Description**

Field of the invention

The present invention relates to multi-channel audio processing and, in particular, to the generation and the use of compact parametric side information to describe the spatial properties of a multi-channel audio signal.

Background of the invention and prior art

In recent times, the multi-channel audio reproduction technique is becoming more and more important. This may be due to the fact that audio compression/encoding techniques such as the well-known mp3 technique have made it possible to distribute audio records via the Internet or other transmission channels having a limited bandwidth. The mp3 coding technique has become so famous because of the fact that it allows distribution of all the records in a stereo format, i.e., a digital representation of the audio record including a first or left stereo channel and a second or right stereo channel.

Nevertheless, there are basic shortcomings of conventional two-channel sound systems. Therefore, the surround technique has been developed. A recommended multi-channel-surround presentation format includes, in addition to two stereo channels L and R, an additional center channel C and two surround channels Ls, Rs. This reference sound format is also referred to as three/two-stereo, which means three front channels and two surround channels. In a playback environment, at least five speakers at five appropriate locations are needed to get an optimum sweet spot in a certain distance of the five well-placed loudspeakers.

Recent approaches for the parametric coding of multi-channel audio signals (parametric stereo (PS), "spatial audio coding", "binaural cue coding" (BCC) etc.) represent a multi-channel audio signal by means of a downmix signal (could be monophonic or comprise several channels) and parametric side information ("spatial cues"), characterizing its perceived spatial sound stage. The different approaches and techniques shall be reviewed shortly in the following paragraphs.

A related technique, also known as parametric stereo, is described in J. Breebaart, S. van de Par, A. Kohlrausch, E. Schuijers, "High-Quality Parametric Spatial Audio Coding at Low Bitrates", AES 116th Convention, Berlin, Preprint 6072, May 2004, and E. Schuijers, J. Breebaart, H. Purnhagen, J. Engdegard, "Low Complexity Parametric Stereo Coding", AES 116th Convention, Berlin, Preprint 6073, May 2004.

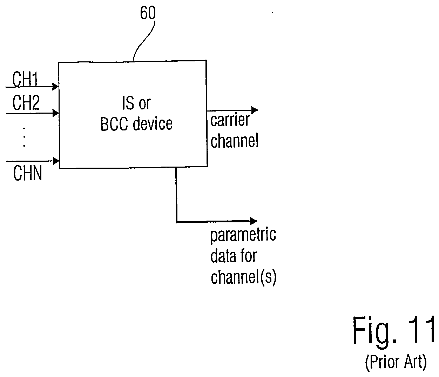

Several techniques are known in the art for reducing the amount of data required for transmission of a multi-channel audio signal. To this end, reference is made to Fig. 11, which shows a joint stereo device 60. This device can be a device implementing e.g. intensity stereo (IS) or binaural cue coding (BCC). Such a device generally receives - as an input - at least two channels (CH1, CH2, ... CHn), and outputs a single carrier channel and parametric data. The parametric data are defined such that, in a decoder, an approximation of an original channel (CH1, CH2, ... CHn) can be calculated.

Normally, the carrier channel will include subband samples, spectral coefficients, time domain samples etc., which provide a comparatively fine representation of the underlying signal, while the parametric data does not include such samples of spectral coefficients but include control parameters for controlling a certain reconstruction algorithm such as weighting by multiplication, time shifting, frequency shifting, phase shifting, etc. The parametric data, therefore, includes only a comparatively coarse representation of the signal or the associated channel. Stated in numbers, the amount of data required by a carrier channel can be in the range of 60 - 70 kbit/s in an MPEG coding scheme, while the amount of data required by parametric side information for one channel may be in the range of about 10 kbit/s for a 5.1 channel signal. An example for parametric data are the well-known scale factors, intensity stereo information or binaural cue parameters as will be described below.

The BCC Technique is for example described in the AES convention paper 5574, "Binaural Cue Coding applied to Stereo and Multi-Channel Audio Compression", C. Faller, F. Baumgarte, May 2002, Munich, in the IEEE WASPAA Paper "Efficient representation of spatial audio using perceptual parametrization", October 2001, Mohonk, NY, and in the 2 ICASSP Papers "Estimation of auditory spatial cues for binaural cue coding", and "Binaural cue coding: a novel and efficient representation of spatial audio", both authored by C. Faller, and F. Baumgarte, Orlando, FL, May 2002.

In BCC encoding, a number of audio input channels are converted to a spectral representation using a DFT (Discrete Fourier Transform) based transform with overlapping windows. The resulting spectrum is divided into nonoverlapping partitions. Each partition has a bandwidth proportional to the equivalent rectangular bandwidth (ERB). The inter-channel level differences (ICLD) and the inter-channel time differences (ICTD) are estimated for each partition. The inter-channel level differences ICLD and inter-channel time differences ICTD are normally given for each channel with respect to a reference channel and furthermore quantized. The transmitted parameters are finally calculated in accordance with prescribed formulae (encoded), which may depend on the specific partitions of the signal to be processed.

At a decoder-side, the decoder receives a mono signal and the BCC bit stream. The mono signal is transformed into the frequency domain and input into a spatial synthesis block, which also receives decoded ICLD and ICTD values. In the spatial synthesis block, the BCC parameters (ICLD and ICTD) values are used to perform a weighting operation of the mono signal in order to synthesize the multi-channel signals, which, after a frequency/time conversion, represent a reconstruction of the original multi-channel audio signal. In case of BCC, the joint stereo module 60 is operative to output the channel side information such that the parametric channel data are quantized and encoded resulting in ICLD or ICTD parameters, wherein one of the original channels is used as the reference channel while coding the channel side information.

Normally, the carrier channel is formed of the sum of the participating original channels.

Therefore, the above techniques additionally provide a suitable mono representation for playback equipment that can only process the carrier channel and is not able to process the parametric data for generating one or more approximations of more than one input channel.

The audio coding technique known as binaural cue coding (BCC) is also well described in the United States patent application publications US 2003, 0219130 A1, 2003/0026441 A1 and 2003/0035553 A1. Additional reference is also made to "Binaural Cue Coding. Part II: Schemes and Applications", C. Faller and F. Baumgarte, IEEE Trans. on Audio and Speech Proc., Vol. 11, No. 6, Nov. 2003 and to "Binaural cue coding applied to audio compression with flexible rendering", C. Faller and F. Baumgarte, AES 113th Convention, Los Angeles, October 2002.

Although ICLD and ICTD parameters represent the most important sound source localization parameters, a spatial representation using these parameters only limits the maximum quality that can be achieved. To overcome this limitation, and hence to enable high-quality parametric coding, Parametric stereo (as described in J. Breebaart, S. van de Par, A. Kohlrausch, E. Schuijers (2005) "Parametric coding of stereo audio", Eurasip J. Applied Signal Proc. 9, 1305-1322) applies three types of spatial parameters, referred to as Interchannel Intensity Differences (IIDs), Interchannel Phase Differences (IPDs), and Interchannel Coherence (IC). The extension of the spatial parameter set with coherence parameters enables a parameterization of the perceived spatial 'diffuseness' or spatial 'compactness' of the sound stage.

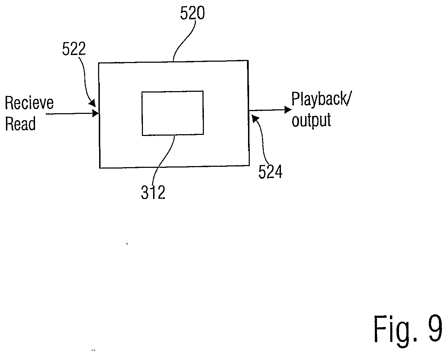

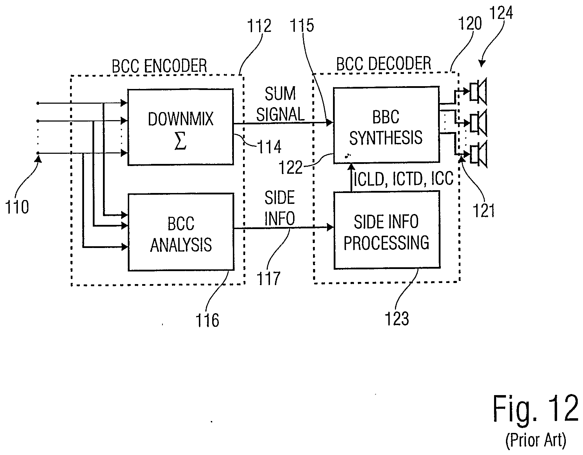

In the following, a typical generic BCC scheme for multi-channel audio coding is elaborated in more detail with reference to Figures 12 to 14. Figure 9 shows such a generic binaural cue coding scheme for coding/transmission of multi-channel audio signals. The multi-channel audio input signal at an input 110 of a BCC encoder 112 is downmixed in a downmix block 114. In the present example, the original multi-channel signal at the input 110 is a 5-channel surround signal having a front left channel, a front right channel, a left surround channel, a right surround channel and a center channel. In a preferred embodiment of the present invention, the downmix block 114 produces a sum signal by a simple addition of these five channels into a mono signal. Other downmixing schemes are known in the art such that, using a multi-channel input signal, a downmix signal having a single channel can be obtained. This single channel is output at a sum signal line 115. A side information obtained by a BCC analysis block 116 is output at a side information line 117. In the BCC analysis block, inter-channel level differences (ICLD), and inter-channel time differences (ICTD) are calculated as has been outlined above. The BCC analysis block 116 is formed to also calculate inter-channel correlation values (ICC values). The sum signal and the side information is transmitted, preferably in a quantized and encoded form, to a BCC decoder 120. The BCC decoder decomposes the transmitted sum signal into a number of subbands and applies scaling, delays and other processing to generate the subbands of the output multi-channel audio signals. This processing is performed such that ICLD, ICTD and ICC parameters (cues) of a reconstructed multi-channel signal at an output 121 are similar to the respective cues for the original multi-channel signal at the input 110 of the BCC encoder 112. To this end, the BCC decoder 120 includes a BCC synthesis block 122 and a side information processing block 123.

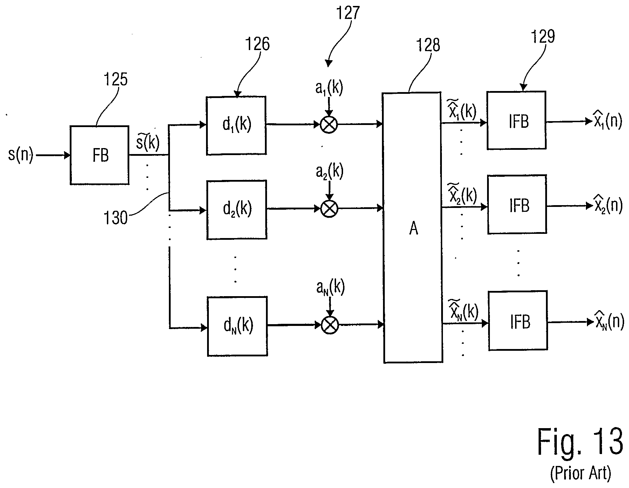

In the following, the internal construction of the BCC synthesis block 122 is explained with reference to Fig. 13. The sum signal on line 115 is input into a time/frequency conversion unit or filter bank FB 125. At the output of block 125, a number N of sub band signals are present, or, in an extreme case, a block of spectral coefficients, when the audio filter bank 125 performs a 1:1 transform, i.e., a transform which produces N spectral coefficients from N time domain samples (critical subsampling).

The BCC synthesis block 122 further comprises a delay stage 126, a level modification stage 127, a correlation processing stage 128 and an inverse filter bank stage IFB 129. At the output of stage 129, the reconstructed multi-channel audio signal having for example five channels in case of a 5-channel surround system, can be output to a set of loudspeakers 124 as illustrated in Fig. 12.

As shown in Fig. 13, the input signal s(n) is converted into the frequency domain or filter bank domain by means of element 125. The signal output by element 125 is multiplied such that several versions of the same signal are obtained as illustrated by branching node 130. The number of versions of the original signal is equal to the number of output channels in the output signal to be reconstructed. When, in general, each version of the original signal at node 130 is subjected to a certain delay $d_1$, $d_2$, ..., $d_i$, ..., $d_N$. The delay parameters are computed by the side information processing block 123 in Fig. 12 and are derived from the inter-channel time differences as determined by the BCC analysis block 116.

The same is true for the multiplication parameters $a_1$, $a_2$, ..., $a_i$, ..., $a_N$, which are also calculated by the side information processing block 123 based on the inter-channel level differences as calculated by the BCC analysis block 116.

The ICC parameters calculated by the BCC analysis block 116 are used for controlling the functionality of block 128 such that certain correlations between the delayed and level-manipulated signals are obtained at the outputs of block 128. It is to be noted here that the ordering of the stages 126, 127, 128 may be different from the case shown in Fig. 13.

One should be aware that, in a frame-wise processing of an audio signal, the BCC analysis is also performed frame-wise, i.e. time-varying, and also frequency-wise. This means that, for each spectral band, the BCC parameters are obtained individually. This further means that, in case the audio filter bank 125 decomposes the input signal into for example 32 band pass signals, the BCC analysis block obtains a set of BCC parameters for each of the 32 bands. Naturally the BCC synthesis block 122 from Fig. 12, which is shown in detail in Fig. 13, performs a reconstruction, which is also based on the 32 bands in the example.

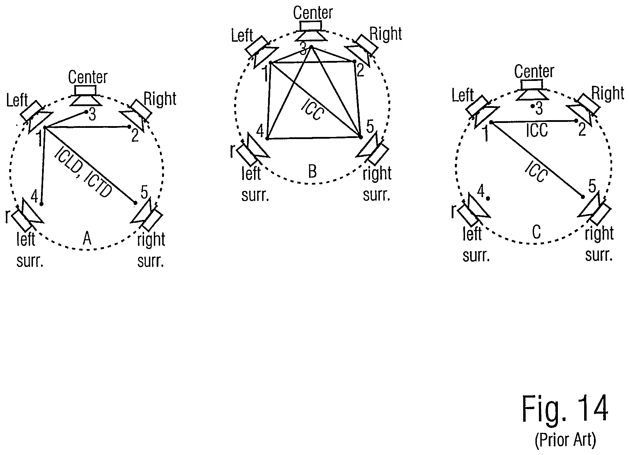

In the following, reference is made to Fig. 14 showing a setup to determine certain BCC parameters. Normally, ICLD, ICTD and ICC parameters can be defined between arbitrary pairs of channels. One method, that will be outlined here, consists of ICLD and ICTD parameters between a reference channel and each other channel. This is illustrated in Fig. 14A.

ICC parameters can be defined in different ways. Most generally, one could estimate ICC parameters in the encoder between all possible channel pairs as indicated in Fig. 14B. In this case, a decoder would synthesize ICC such that it is approximately the same as in the original multi-channel signal between all possible channel pairs. It was, however, proposed to estimate only ICC parameters between the strongest two channels at a time. This scheme is illustrated in Fig. 14C, where an example is shown, in which at one time instance, an ICC parameter is estimated between channels 1 and 2, and, at another time instance, an ICC parameter is calculated between channels 1 and 5. The decoder then synthesizes the inter-channel correlation between the strongest channels in the decoder and applies some heuristic rule for computing and synthesizing the inter-channel coherence for the remaining channel pairs.

Regarding the calculation of, for example, the multiplication parameters $a_1$, ..., $a_N$ based on transmitted ICLD parameters, reference is made to AES convention paper 5574 cited above. The ICLD parameters represent an energy distribution in an original multi-channel signal. Without loss of generality, it is shown in Fig. 14A that there are four ICLD parameters showing the energy difference between all other channels and the front left channel. In the side information processing block 123, the multiplication parameters $a_1$, ..., $a_N$ are derived from the ICLD parameters such that the total energy of all reconstructed output channels is the same as (or proportional to) the energy of the transmitted sum signal. A simple way for determining these parameters is a 2-stage process, in which, in a first stage, the multiplication factor for the left front channel is set to unity, while multiplication factors for the other channels in Fig. 14A are determined from the transmitted ICLD values. Then, in a second stage, the energy of all five channels is calculated and compared to the energy of the transmitted sum signal. Then, all channels are downscaled using a downscaling factor which is equal for all channels, wherein the downscaling factor is selected such that the total energy of all reconstructed output channels is, after downscaling, equal to the total energy of the transmitted sum signal.

Naturally, there are also other methods for calculating the multiplication factors, which do not rely on the 2-stage process but which only need a 1-stage process.

Regarding the delay parameters, it is to be noted that the delay parameters ICTD, which are transmitted from a BCC encoder can be used directly, when the delay parameter $d_1$ for the left front channel is set to zero. No rescaling has to be done here, since a delay does not alter the energy of the signal.

As has been outlined above with respect to Fig. 14, the parametric side information, i.e., the interchannel level differences (ICLD), the interchannel time differences (ICTD) or the interchannel coherence parameter (ICC) can be calculated and transmitted for each of the five channels. This means that one, normally, transmits four sets of interchannel level differences for a five channel signal. The same is true for the interchannel time differences. With respect to the interchannel coherence parameter, it can also be sufficient to only transmit for example two sets of these parameters.

As has been outlined above with respect to Fig. 13, there is not a single level difference parameter, time difference parameter or coherence parameter for one frame or time portion of a signal. Instead, these parameters are determined for several different frequency bands so that a frequency-dependent parametrization is obtained. Since it is preferred to use for example 32 frequency channels, i.e., a filter bank having 32 frequency bands for BCC analysis and BCC synthesis, the parameters can occupy quite a lot of data. Although - compared to other multi-channel transmissions - the parametric representation results in a quite low data rate, there is a continuing need for further reduction of the necessary data rate to represent a signal having more than two channels such as a multi-channel surround signal.

The encoding of a multi-channel audio signal can be advantageously implemented using several existing modules, which perform a parametric stereo coding into a single mono-channel. The international patent application WO2004008805 A1 teaches how parametric stereo coders can be ordered in a hierarchical set-up such, that a given number of input audio channels are subsequently downmixed into one single mono-channel. The parametric side information, describing the spatial properties of the downmix mono-channel, finally consists of all the parametric information subsequently produced during the iterative downmixing process. This means, that, if there are, for example, three stereo-to-mono downmixing processes involved in building the final mono signal, the final set of parameters building the parametric representation of the multi-channel audio signal consists of the three sets of the parameters derived during every single stereo-to-mono downmixing process.

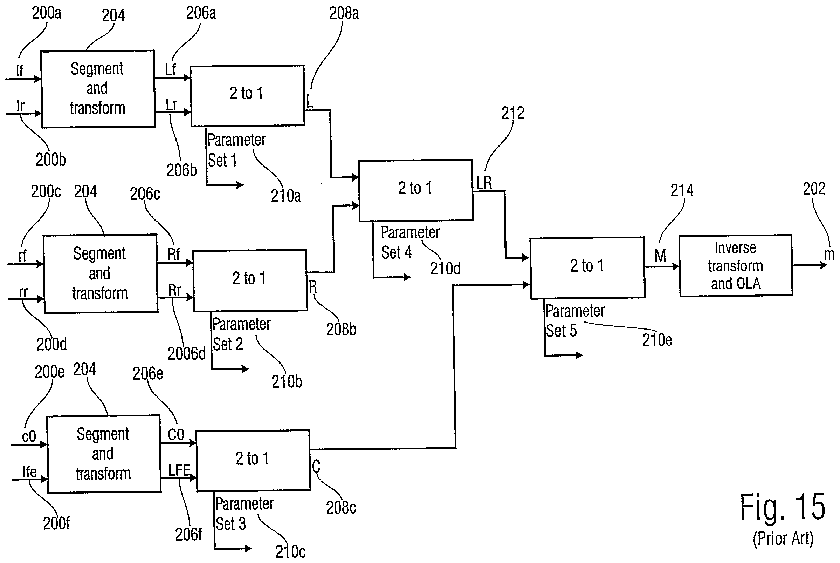

A hierarchical downmixing encoder is shown in Fig. 15, to explain the method of the prior art in more detail. Fig. 15 shows six original audio channels 200a to 200f that are transformed into a single monophonic audio channel 202 plus parametric side information. Therefore, the six original audio channels 200a to 200f have to be transformed from the time domain into the frequency domain, which is performed by transforming units 204, transforming the audio channels 200a to 200f into the corresponding channels 206a to 206f in the frequency domain. Following the hierarchical approach, the channels 206a to 206f are pair-wise downmixed into three monophonic channels L, R and C (208a, 208b and 208c, respectively). During the downmixing of the three pairs of channels a parameter set is derived for each channel pair, describing the spatial properties of the original stereophonic signal, downmixed into a monophonic signal. Thus, in this first downmixing step, three parameter sets 210a to 210c are generated to preserve the spatial information of the signals 206a to 206f.

In the next step of the hierarchical downmixing, channels 208a and 208b are downmixed into a channel 212 (LR), generating a parameter set 210d (parameter set 4. To finally derive only one single monophonic channel, a downmixing of the channels 208c and 212 is necessary, resulting in channel 214 (M). This generates a fifth parameter set 210e (parameter set 5). Finally, the downmixed monophonic audio signal 214 is inversely transformed into the time domain to derive an audio signal 202 that can be played by standard equipment.

As described above, a parametric representation of the downmix audio signal 202 according to the prior art consists of all the parameter sets 210a to 210e, which means that if one wants to rebuild the original multi-channel audio signal (channels 200a to 200f) from the monophonic audio signal 202, all the parameter sets 210a to 210e are required as side information of the monophonic downmix signal 202.

The US-patent application 11/032,689 (from here only referred to as "prior art cue combination") describes a process for combining several cue values into a single transmitted one in order to save side information in a non-hierarchical coding scheme. To do so, all the channels are downmixed first and the cue codes are later on combined to form transmitted cue values (could also be one single value), the combination being dependent on a predefined mathematical function, in which the spatial parameters, that are derived directly from the input signals, are put in as variables.

State-of-the-art techniques for the parametric coding of two ("stereo") or more ("multi-channel") audio input channels derive the spatial parameters directly from the input signals. Examples of such parameters are interchannel level differences (ICLD) or inter-channel intensity differences (IID), inter-channel time delay (ICTD) or interchannel phase differences (IPD), and inter-channel correlation/coherence (ICC), each of which are transmitted in a frequency-selective fashion, i.e. per frequency band. The application of the prior art cue combination teaches that several cue values can be combined to a single value that is transmitted from the encoder to the decoder side. The decoding process uses the transmitted single value instead of the originally individually transmitted cue values to reconstruct the multi-channel output signal. In a preferred embodiment, this scheme has been applied to the ICC parameters. It has been shown that this leads to a considerable reduction in the size of the cue side information while preserving the spatial quality of the vast majority of signals. It is, however, not clear how this can be exploited in a hierarchical coding scheme.

The patent application on prior art cue combination has detailed the principle of the invention by an example for a system based on two transmitted downmix channels. In the proposed method, with reference to figure 15, ICC values of Lf/Lr and Rf/Rr channel pairs are combined into a single transmitted ICC parameter. The two combined ICC values have been obtained during the downmixing of a front-left channel Lf and a rear-left channel Lr into the channel L and during the downmixing of a front-right Rf and a rear-right channel Rr into the channel R. Therefore, the two combined ICC values that are finally being combined into the single transmitted ICC parameter, both carry information about the front/back correlation of the original channels and a combination of these two ICC values will generally preserve most of this information. If one would have to further downmix the L and R channels into one single mono channel, one would get a third ICC value, carrying information about the left/right correlation of the downmix channels L and R. According to the cue combination of prior art, one would now have to combine the three ICC values applying a given function transforming the three ICC values into one transmitted ICC parameter.

One has the problem then that front/back information mixes with left/right information, which is obviously disadvantageous for a reproduction of the original multi-channel audio signal. In the US-application 11/032,689, this is avoided by transmitting two downmix channels, the L and R channels, that hold the left/right information, and additionally transmitting one single ICC value, holding front/back information. This preserves the spatial properties of the original channels at the cost of a substantially increased data rate, resulting from the full additional downmix channel to be transmitted.

Several other publications and patent applications relate to the topic of coding multiple channels using parametric representations of the channels. For example, US 2003/0219130 A1 relates to coherence-based audio coding and synthesis, where an auditory scene is synthesized from a mono audio signal by modifying, for each critical band, an auditory scene parameter (e.g. an inter-channel-level difference, (ILD) and/or an inter-channel-time difference (ITD)) for each subband within the critical band. The modification is based on an average estimated coherence for the critical band. The coherence-based modification produces auditory scenes having objects whose widths more accurately match the widths of the objects in the original input auditory scene.

Summary of the invention

It is the object of the present invention to provide an improved concept to generate and to use a parametric representation of a multi-channel audio signal with compact side information in the context of a hierarchical coding scheme

This object is achieved by an encoder of claim 1, a decoder of claim 14, a method for generating of claim 25, a method for processing of claim 26, encoded audio data of claim 27, a computer readable storage medium of claim 28, a receiver of audio player of claim 29, a transmitter or audio recorder of claim 30, a method of receiving or audio playing of claim 31, a method of transmitting or audio recording of claim 32, a transmission system of claim 33, a method of transmitting or receiving of claim 34, or a computer program of claim 35.

The present invention is based on the finding that a parametric representation of a multi-channel audio signal sdescribes the spatial properties of the audio signal well using compact side information, when the coherence information, describing the coherence between a first and a second channel, is derived within a hierarchical encoding process only for channel pairs including a first channel having only information of a left side with respect to a listening position and including a second channel having only information from a right side with respect to a listening position. As in the hierarchical process the multiple audio channels of the original audio signal are downmixed iteratively preferably into a monophonic channel, one has the chance to pick the relevant side-information parameters during the encoding process for a step involving only channel pairs that bear the desired information needed to describe the spatial properties of the original audio signal as good as possible. This allows to build a parametric representation of the original audio signal on the basis of those picked parameters or on a combination of those parameters, allowing a significant reduction of the size of the side information, that is holding the spatial information of the downmix signal.

The proposed concept allows combining cue values to reduce the side information rate of a downmix audio signal even for the case where only a single (monophonic) transmission channel is feasible. The inventive concept even allows different hierarchical topologies of the encoder. It is specifically clarified, how a suitable single ICC value can be derived, which can be applied in a spatial audio decoder using the hierarchical encoding/decoding approach to reproduce the original sound image faithfully.

One embodiment of the present invention implements a hierarchical encoding structure that combines the left front and the left rear audio channel of a 5.1 channel audio signal into a left master channel and that simultaneously combines the right front and the right rear channel into a right master channel. Combining the left channels and the right channels separately, the important left/right coherence information is mainly preserved and is, according to the invention, derived in the second encoding step, in which the left master and the right master channels are downmixed into a stereo master channel. During this downmixing process the ICC parameter for the whole system is derived, since this ICC parameter will be the ICC parameter resembling with most accuracy the left/right coherence. Within this embodiment of the present invention, one gets an ICC parameter, describing the most important left/right coherence of the six audio channels by simply arranging the hierarchical encoding steps in an appropriate way and not by applying some artificial function to a set of ICC parameters, describing arbitrary pairs of channels, as it is the case in the prior art techniques.

In a modification of the described embodiment of the present invention, the center channel and the low frequency channel of the 5.1 audio signal are downmixed into a center master channel, this channel holding mainly information about the center channel, since the low frequency channel contains only signals with such a low frequency that the origin of the signals can hardly be localized by humans. It can be advantageous to additionally steer the ICC value, derived as described above, by parameters describing the center master channel. This can be done, for example, by weighting the ICC value with energy information, the energy information telling how much energy is transmitted via the center master channel with respect to the stereo master channel.

In a further embodiment of the present invention, the hierarchical encoding process is performed such, that in a first step the left-front and right-front channels of a 5.1 audio signal are downmixed into a front master channel, whereas the left-rear and the right-rear channels are downmixed into a rear master channel. Therefore, in each of the downmixing processes an ICC value is generated, containing information about the important left/right coherence. The combined and transmitted ICC parameter is then derived from a combination of the two separate ICC values, an advantageous way of deriving the transmitted ICC parameter is to build the weighted sum of the ICC values, using the level parameters of the channels as weights.

In a modification of the invention, the center channel and the low frequency channel are downmixed into a center master channel and afterwards the center master channel and the front master channel are downmixed into a stereo master channel. In the latter downmixing process, a correlation between the center and the stereo channels is received, which is used to steer or modify a transmitted ICC parameter, thus also taking into account the center contribution to the front audio signal.

A major advantage of the previously described system is that one can build the coherence information such that channels, that contribute most to the audio signal, mainly define the transmitted ICC value. This will normally be the front channels, but for example in a multi-channel representation of a music concert, the signal of the applauding audience could be emphasized by mainly using the ICC value of the rear channels. It is a further advantage that the weighting between the front and the back channels can be varied dynamically, depending on the spatial properties of the multi-channel audio signal.

In one embodiment of the present invention an inventive hierarchical decoder is operative to receive less ICC parameters than required by the number of existing decoding steps. The decoder is operational to derive the ICC parameters required for each decoding step from the received ICC parameters.

This might be done deriving the additional ICC parameters using a deriving rule that is based on the received ICC parameters and the received ICLD values or by using predefined values instead.

In a preferred embodiment, however, the decoder is operational to use a single transmitted ICC parameter for each individual decoding step. This is advantageous as the most important correlation, the left/right correlation is preserved in a transmitted ICC parameter within the inventive concept. As this is the case, a listener will experience a reproduction of the signal that is resembling the original signal very well. It is to be remembered that the ICC parameter is defining the perceptual wideness of a reconstructed signal. If the decoder would modify a transmitted ICC parameter after transmission, the ICC parameters describing the perceptual wideness of the reconstructed signal may become rather different for the left/right and for the front/back correlation within the hierarchical reproduction. This would be most disadvantageous since then, a listener that moves or rotates his head will experience a signal that becomes perceptually wider or narrower, which is of course most disturbing. This can be avoided by distributing a single received ICC parameter to the decoding units of a hierarchical decoder.

In another preferred embodiment, an inventive decoder is operational to receive a full set of ICC values or alternatively a single ICC value, wherein the decoder recognizes the decoding strategy to apply by receiving a strategy indication within the bitstream. Such the backwards compatible decoder is also operational in prior art environments, decoding prior art signals transmitting a full set of ICC data.

## Brief description of the drawings

Preferred embodiments of the present invention are subsequently described by referring to the enclosed drawings, wherein:

Fig. 1 shows a block diagram of an embodiment of the inventive hierarchical audio encoder;

Fig. 2 shows an embodiment of an inventive audio encoder;

Fig. 2a shows a possible steering scheme of an IIC parameters of an inventive audio encoder;

Fig. 3a,b shows graphical representations of side channel information;

Fig. 4 shows a second embodiment of an inventive audio encoder;

Fig. 5 shows a block diagram of a preferred embodiment of an inventive audio decoder;

Fig. 6 shows an embodiment of an inventive audio decoder;

Fig. 7 shows another embodiment of an inventive audio decoder;

Fig. 8 shows an inventive transmitter or audio recorder;

Fig. 9 shows an inventive receiver or audio player;

Fig. 10 shows an inventive transmission system;

Fig. 11 shows a prior art joint stereo encoder;

Fig. 12 shows a block diagram representation of a prior art BCC encoder/decoder chain;

Fig. 13 shows a block diagram of a prior art implementation of a BCC synthesis block;

Fig. 14 shows a representation of a scheme for determining BCC parameters; and

Fig. 15 shows a prior art hierarchical encoder.

## Detailed Description of Preferred Embodiments

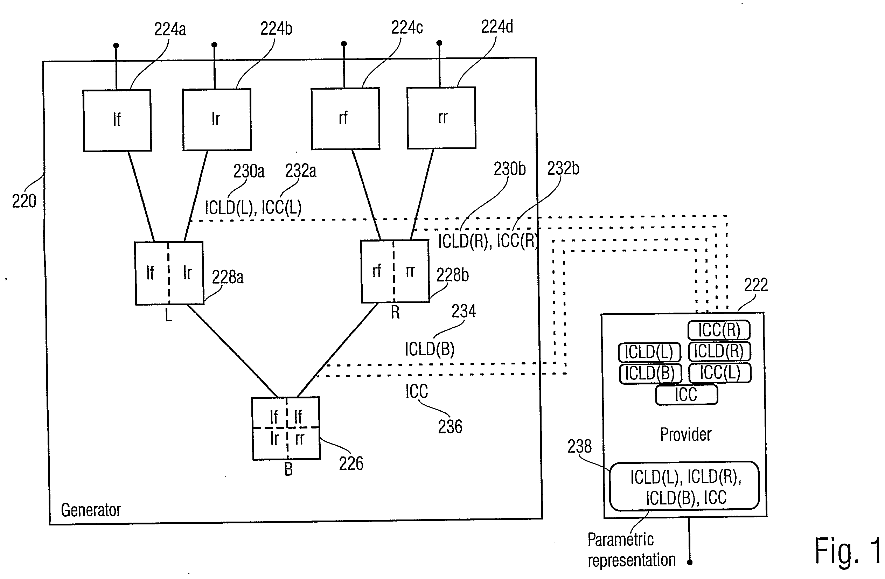

Fig. 1 shows a block diagram of an inventive encoder to generate a parametric representation of an audio signal. Fig. 1 shows a generator 220 to subsequently combine audio channels and generate spatial parameters describing spatial properties of pairs of channels that are combined into a single channel. Fig. 1 further shows a provider 222 to provide a parametric representation of a multi-channel audio signal by selecting level difference information between channel pairs and by determining a left/right coherence measure using coherence information generated by the generator 220.

To demonstrate the principle of the inventive concept of hierarchical multi-channel audio coding, Fig.

1 shows a case, where four original audio channels 224a to 224d are iteratively combined, resulting in a single channel 226. The original audio channels 224a and 224b represent the left-front and the left-rear channel of an original four-channel audio signal, the channels 224c and 224d represent the right-front and the right-rear channel, respectively. Without loss of generality, only two of various spatial parameters are shown in Fig. 1 (ICLD and ICC). According to the invention, the generator 220 combines the audio channels 224a to 224d in such a way that during the combination process an ICC parameter can be derived that carries the important left/right coherence information.

In a first step, the channels containing only left side information 224a and 224b are combined into a left master channel 228a (L) and the two channels containing only right side information 224c and 224d are combined into a right master channel 228b (R). During this combination the generator generates two ICLD parameters 230a and 230b, both being spatial parameters containing information about the level difference of two original channels being combined into one single channel. The generator also generates two ICC parameters 232a and 232b, describing the correlation between the two channels being combined into a single channel. The ICLD and ICC parameters 230a, 230b, 232a, and 232b are transferred to the provider 222.

In the next step of the hierarchical generation process, the left master channel 228a is combined with the right master channel 228b into the resulting audio channel 226, wherein the generator provides an ICLD parameter 234 and an ICC parameter 236, both of them being transmitted to the provider 222. It is important to note that the ICC parameter 236 generated in this combination step mainly represents the important left/right coherence information of the original four-channel audio signal represented by the audio channels 224a to 224d.

Therefore, the provider 222 builds a parametrical representation 238 from the available spatial parameters 230a,b, 232a,b, 234 and 236 such, that the parametrical representation comprises the parameters 230a, 230b, 234, and 236.

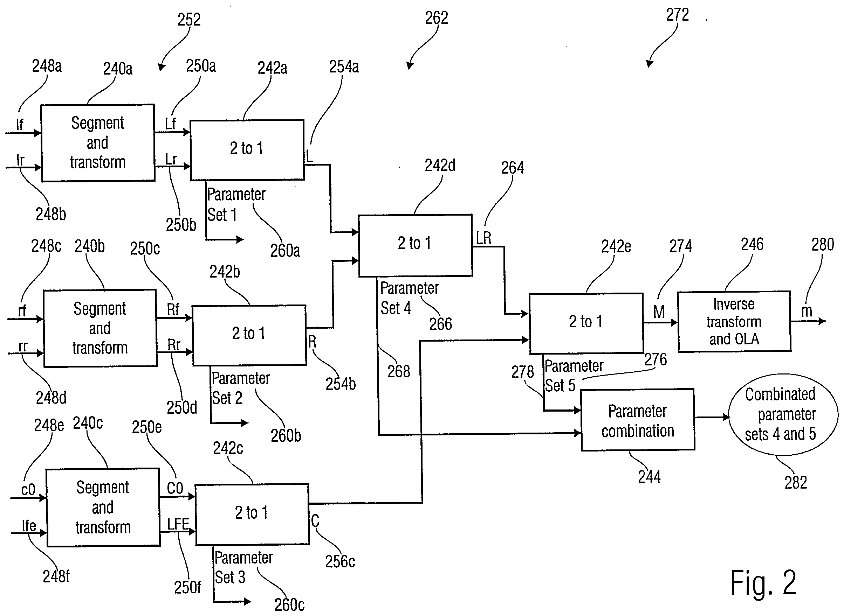

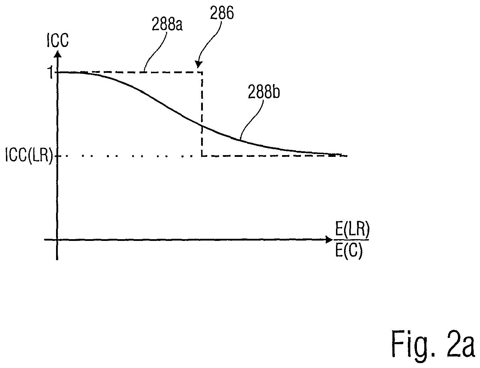

Fig. 2 shows a preferred embodiment of an inventive audio encoder that encodes a 5.1 multi-channel signal into a single monophonic signal.

Fig. 2 shows three transformation units 240a to 240c, five 2-to-1-downmixers 242a to 242e, a parameter combination unit 244 and an inverse transformation unit 246. The original 5.1 channel audio signal is given by the left-front channel 248a, the left-rear channel 248b, the right-front channel 248c, the right-rear channel 248d, the center channel 248e, and the low-frequency channel 248f. It is important to note that the original channels are grouped in such a way that the channels containing only left side information 248a and 248b form one channel pair, the channels containing only right side information 248c and 248d form another channel pair and that the center channel 248e and 248f are forming a third channel pair.

The transformation units 240a to 240c convert the channels 248a to 248f from the time domain into their spectral representation 250a to 250f in the frequency subband domain. In the first hierarchical encoding step 252, the left channels 250a and 250b are encoded into a left master channel 254a, the right channels 250c and 250d are encoded into a right master channel 254b and the center channel 250e and the low frequency channel 250f are encoded into a center master channel 256. During this first hierarchic encoding step 252, the three involved 2-to-1-encoders 242a to 242c generate the downmixed channels 254a, 254b, and 256, and in addition the important spatial parameter sets 260a, 260b, and 260c, wherein the parameter set 260a (parameter set 1) describes the spatial information between channels 250a and 250b, the parameter set 260b (parameter set 2) describes the spatial relation between channels 250c and 250d and the parameter set 260c (parameter set 3) describes the spatial relation between channels 250e and 250f.

In a second hierarchical step 262, the left master channel 254a and the right master channel 254b are downmixed into a stereo master channel 264, generating a spatial parameter set 266 (parameter set 4), wherein the ICC parameter, of this parameter set 266 contains the important left/right correlation information. To build a combined ICC value from parameter set 266, the parameter set 266 can be transferred to the parameter combination unit 244 via a data connection 268. In the third hierarchical encoding step 272, the stereo master channel 264 is combined with the center master channel 256 to form a monophonic result channel 274. The parameter set 276, that is derived during this downmixing process, can be transferred via a data connection 278 to the parameter combination unit 244. Finally, the result channel 274 is transformed into the time domain by the inverse transformation unit 246, to build the monophonic downmix audio signal 280, which is the final monophonic representation of the original 5.1 channel signal represented by the audio channels 248a to 248f.

To reconstruct the original 5.1 channel audio signal from the monophonic downmix audio channel 280, the parametric representation of the 5.1 channel audio signal is additionally needed. For the tree structure shown in Fig. 2, it can be seen that the left front and back channels are combined into an L-signal 254a. Similarly, the right front and back channels are combined into an R-signal 254b. Subsequently, the combination of the L and R-signals is carried out, which delivers parameter set number 4 (266). In the case of this hierarchical structure, a simple way of deriving a combined ICC value is to pick the ICC value of parameter set number 4 and take this as combined ICC value, which is then incorporated into the parametric representation of the 5.1 channel signal by the parameter combination unit 244. More sophisticated methods can also take into account the influence of the center channel (e.g. by using parameters from parameter set number 5), as shown in Fig. 2a.

As an example, the energy ratio E(LR)/ E(C) of the energy contained in the LR (264) channel and in the C channel (256) from parameter set number 5 can be used to steer the ICC of value. In case most of the energy comes from the LR path, the transmitted ICC value should become close to the ICC value ICC(LR) of parameter set number 4. In case most of the energy comes from the C-path 256, the transmitted ICC value should become subsequently close to 1, as indicated in Fig. 2a. The Figure shows two possible ways to implement this steering of the ICC Parameter either by switching between two extreme values when the energy ratio crosses a given threshold 286 (steering function 288a) or by a smooth transition between the extreme values (steering function 288b).

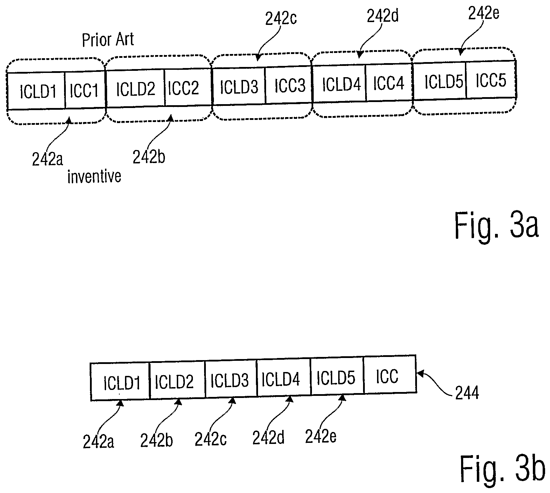

Figures 3a and 3b show a comparison of a possible parametric representation of a 5.1 audio channel delivered from a hierarchical encoder structure using a prior art technique (Fig. 3a) and using the inventive concept for audio coding (Fig. 3b).

Fig. 3a shows a parametric representation of a single time frame and a discrete frequency interval, as it would be provided by the prior art technique. Each of the 2-to-1 encoders 242a to 242e from Fig. 2 delivers one pair of ICLD and ICC parameters, the origin of the parameter pairs is indicated within Fig. 3a. Following the prior art approach, all parameter sets, as provided by the 2-to-1 encoders 242a to 242e have to be transmitted together with the downmix monophonic audio signal 280 as side information to rebuild a 5.1 channel audio signal.

Fig. 3b shows parameters derived following the inventive concept. Each of the 2-to-1 encoders 242a to 242e contributes only one parameter directly, the ICLD parameter. The single transmitted ICC parameter $ICC_c$ is derived by the parameter combination unit 244, and not provided directly by the 2-to-1 encoders 242a to 242e. As it is clearly seen in the figures 3a and 3b, the inventive concept for a hierarchical encoder can reduce the amount of side information data significantly compared to prior art techniques.

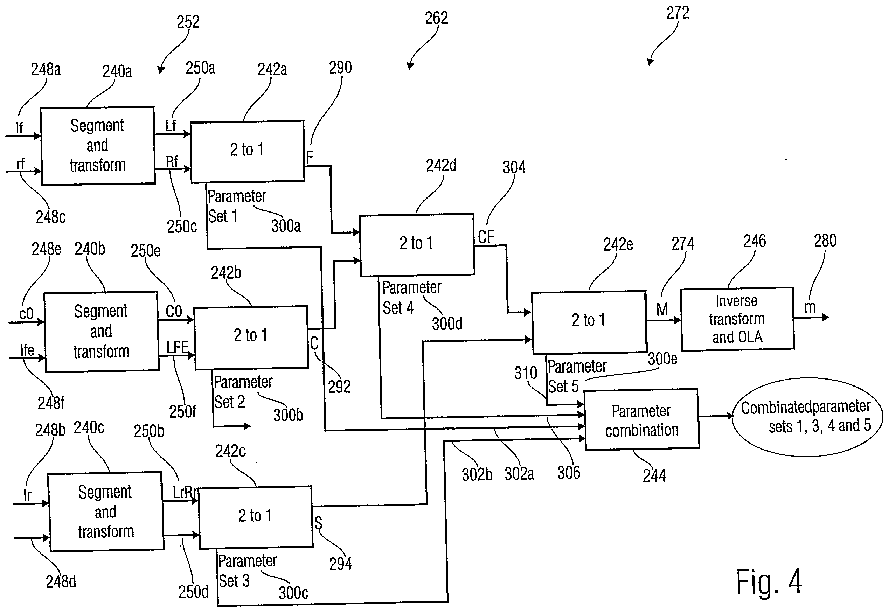

Fig. 4 shows another preferred embodiment of the current invention, allowing to encode a 5.1 channel audio signal into a monophonic audio signal in a hierarchical encoding process and to supply compact side information. As the principle hardware structure is equal to the one described in Fig. 2, the same items in the two figures are labeled with the same numbers. The difference is due to the different grouping of the input channels 248a to 248f and hence the order, in which the single channels are downmixed into the monophonic channel 274 differs from the downmixing order in Fig.2. Therefore, only the aspects differing from the description of Fig. 2, which are vital for the understanding of the embodiment of the current invention shown in Fig. 4, are described in the following.

The left-front channel 248a and the right-front channel 248c are grouped together to form a channel pair, the center channel 248e and the low-frequency channel 248f form another input channel pair and the third input channel pair of the 5.1 audio signal is formed by the left-rear channel 248b and the right-rear channel 248d.

In a first hierarchical encoding step 252, the left-front channel 250a and the right-front channel 250c are downmixed into a front master channel 290 (F), the center channel 250e and the low-frequency channel 250f are downmixed into a center master channel 292 (C) and the left-rear channel 250b and the right-rear channel 250d are downmixed into a rear master channel 294 (S). A parameter set 300a (parameter set 1) describes the front master channel 290, a parameter set 300b (parameter set 2) describes the center master channel 292, and a parameter set 300c (parameter set 3) describes the rear master channel 294.

It is important to note that the parameter set 300a as well as the parameter set 300c hold information that describes the important left/right correlation between the original channels 248a to 248f. Therefore, parameter set 300a and parameter set 300c is made available to the parameter combination unit 244 via data links 302a and 302b.

In a second encoding step 262, the front master channel.290 and the center master channel 292 are downmixed into a pure front channel 304, generating a parameter set 300d (parameter set 4). This parameter set 300d is also made available to the parameter combination unit 244 via a data link 306.

In a third hierarchical encoding step 272, the pure front channel 304 is downmixed with the rear master channel 294 into the result channel 274 (M), which is then transformed into the time domain by the inverse transformation unit 246 to form the final monophonic downmix audio channel 280. The parameter set 300e (Parameter Set 5), originating from the downmixing of the pure front channel 304 and the rear master channel 294 is also made available to the parameter combination unit 244 via a data link 310.

The tree structure in Fig. 4 first performs a combination of the left and right channels separately for front and rear. Thus, basic left/right correlation/coherence is present in the parameter sets 1 and 3 (300a, 300c). A combined ICC value could be built by the parameter combination unit 244 by building the weighted average between the ICC values of parameter sets 1 and 3. This means that more weight will be given to stronger channel pairs (Lf/Rf versus Lr/Rr). One can achieve the same by deriving a combined ICC Parameter $ICC_c$ building the weighted sum:

$$ICC_c = (A * ICC_1 + B * ICC_2)/(A+B)$$

wherein A denotes the energy within the pair of channels corresponding to $ICC_1$ and B denotes the energy within the pair of channels corresponding to $ICC_2$.

In an alternative embodiment, more sophisticated methods can also take into account the influence of the center channel (e.g. by taking into account parameters of the parameter set number 4).

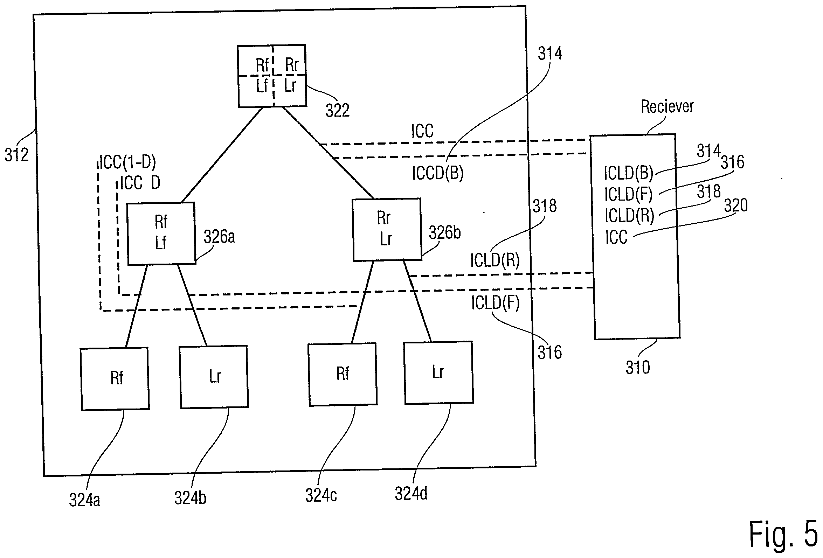

Fig. 5 shows an inventive decoder, to process received compact side information, being a parametric representation of an original four-channel audio signal. Fig. 5 comprises a receiver 310 to provide a compact parametric representation of the four-channel audio signal and a processor 312 to process the. compact parametric representation such that a full parametric representation of the four-channel audio signal is supplied, which enables one to reconstruct the four-channel audio signal from a received monophonic audio signal.

The receiver 310 receives the spatial parameters ICLD (B) 314, ICLD (F) 316, ICLD (R) 318 and ICC 320. The provided parametric representation, consisting of the parameters 314 to 320, describes the spatial properties of the original audio channels 324a to 324d.

As a first up-mixing step, the processor 312 supplies the spatial parameters describing a first channel pair 326a, being a combination of two channels 324a and 324b (Rf and Lf) and a second channel pair 326b, being a combination of two channels 324c and 324d (Rr and Lr). To do so, the level difference 314 of the channel pairs is required. Since both channel pairs 326a and 326b contain a left channel as well as a right channel, the difference between the channel pairs describes mainly a front/back correlation. Therefore, the received ICC parameter 320, carrying mainly information about the left/right coherence, is provided by the processor 312 such that the left/right coherence information is preferably used to supply the individual ICC parameters for the channel pairs 326a and 326b.

In the next step, the processor 312 supplies appropriate spatial parameters to be able to reconstruct the single audio channels 324a and 324b from channel 326a, and the channels 324c and 324d from channel 326b. To do so, the processor 312 supplies the level differences 316 and 318, and the processor 312 has to supply appropriate ICC values for the two channel pairs, since each of the channel pairs 326a and 326b contains important left/right coherence information.

In one example, the processor 312 could simply provide the combined received ICC value 320 to up-mix channel pairs 326a and 326b. Alternatively, the received combined ICC value 320 could be weighted to derive individual ICC values for the two channel pairs, the weights being for example based on the level difference 314 of the two channel pairs.

In a preferred embodiment of the present invention, the processor provides the received ICC parameter 320 for every single upmixing step to avoid the introduction of additional artefacts during the reproduction of the channels 324a to 324d.

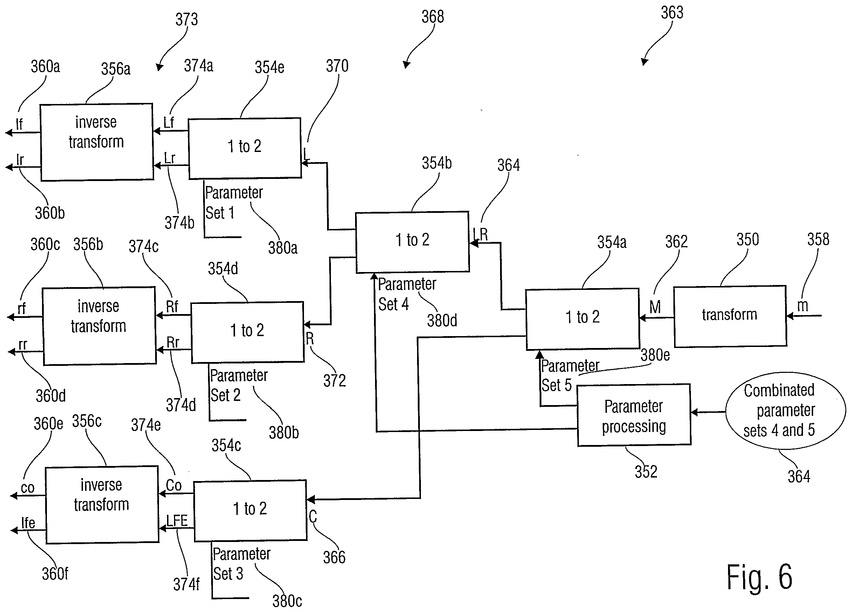

Fig. 6 shows a preferred embodiment of a decoder incorporating a hierarchical decoding procedure according to the current invention, to decode a monophonic audio signal to a 5.1 multi-channel audio signal, making use of a compact parametric representation of an original 5.1 audio signal.

Fig. 6 shows a transforming unit 350, a parameter-processing unit 352, five 1-to-2 decoders 354a to 354e and three inverse transforming units 356a to 356c.

It should be noted that the embodiment of an inventive decoder according to Fig. 6 is the counterpart of the encoder described in Fig. 2 and designed to receive a monophonic downmix audio channel 358, which shall finally be up-mixed into a 5.1 audio signal consisting of audio channels 360a (lf), 360b (lr), 360c (rf), 360d (rr), 360e (co) and 360f (lfe). The downmix channel 358 (m) is received and transformed from the time domain to the frequency domain into its frequency representation 362 using the transforming unit 350. The parameter-processing unit 352 receives a combined and compact set of spatial parameters 364 in parallel with the downmix channel 358.

In a first step 363 of the hierarchical decoding process, the monophonic downmix channel 362 is up-mixed into a stereo master channel 364 (LR) and a center master channel 366 (C) .

In a second step 368 of the hierarchical decoding process, the stereo master channel 364 is up-mixed into a left master channel 370 (L) and a right master channel 372 (R).

In a third step of the decoding process, the left master channel 370 is up-mixed into a left-front channel 374a and a left-rear channel 374b, the right master channel 372 is up-mixed into a right-front channel 374c and right-rear channel 374d, and the center master channel 366 is up-mixed to a center channel 374e and a low-frequency channel 374f.

Finally, the six single audio channels 374a to 374f are transformed by the inverse transforming units 356a to 356c into their representation in the time domain and thus build the reconstructed 5.1 audio signal, having six audio channels 360a to 360f. To retain the original spatial property of the 5.1 audio signal, the parameter processing unit 352, especially the way the parameter processing unit provides the individual parameter sets 380a to 380e, is vital, especially the way the parameter processing unit 352 derives the individual parameter sets 380a to 380e.

The received combined ICC parameter describes the important left/right coherence of the original six channel audio signal. Therefore, the parameter processing unit 352 builds the ICC value of parameter set 4 (380d) such that it resembles the left/right correlation information of the originally received spatial value, being transmitted within the parameter set 364. In the simplest possible implementation the parameter processing unit 352 simply uses the received combined ICC parameter.

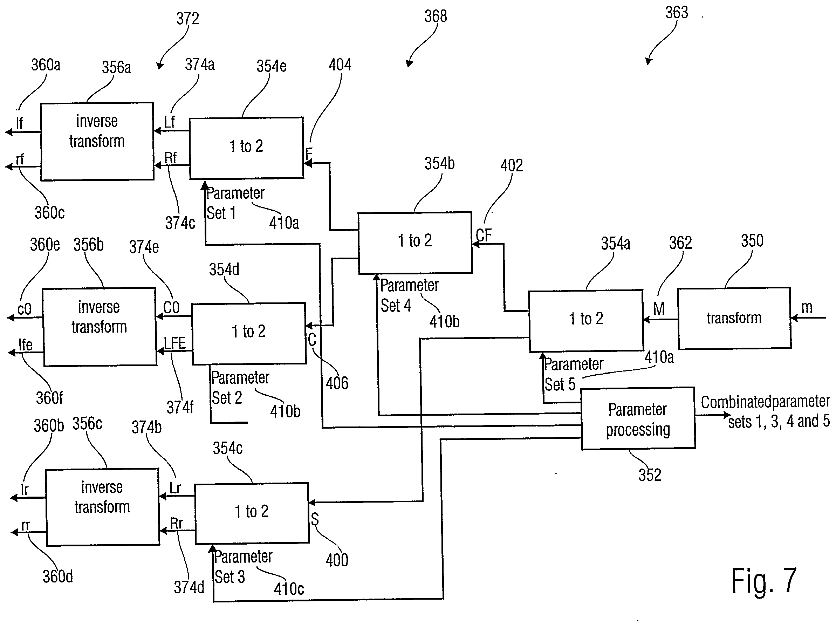

Another preferred embodiment of a decoder according to the current invention is shown in Fig. 7, the decoder in Fig. 7 being the counterpart of the encoder from Fig. 4.

As the encoder in Fig. 7 comprises the same functional blocks as the decoder in Fig. 6, the following discussion is limited to the steps in which the hierarchical decoding process differs from the one in Fig. 6. This is mainly due to the fact that the monophonic signal 362 is up-mixed in a different order and a different channel combination, since the original 5.1 audio signal had been downmixed differently than the one received in Fig. 6.

In the first step 363 of the hierarchical decoding process, the monophonic signal 362 is up-mixed into a rear master channel 400 (S) and a pure front channel 402 (CF).

In a second step 368, the pure front channel 402 is up-mixed into a front master channel 404 and a center master channel 406.

In a third decoding step 372, the front master channel is up-mixed into a left-front channel 374a and a right-front channel 374c, the center master channel 406 is up-mixed into a center channel 374e and a low-frequency channel 374f and the rear master channel 400 is up-mixed into a left-rear channel 374b and a right-rear channel 374d. Finally, the six audio channels 374a to 374f are transformed from the frequency domain into their time-domain representations 360a to 360f, building the reconstructed 5.1 audio signal.

To preserve the spatial properties of the original 5.1 signal, having been coded as side information by the encoder, the parameter processing unit 352 supplies the parameter sets 410a to 410e for the 1-to-2 decoders 354a to 354e. As the important left/right correlation information is needed in the third up-mixing process 372 to build the Lf, Rf, Lr, and Rr channels, the parameter-processing unit 352 may supply an appropriate ICC value in the parameter sets 410a and 410c, in the simplest implementation simply taking the transmitted ICC parameter to build the parameter sets 410a and 410c. In a possible alternative, the received ICC parameter could be transformed into individual parameters for parameter sets 410a and 410c by applying a suitable weighting function to the received ICC parameter, their weight being for example dependent on the energy transmitted in the front master channel 404 and in the rear master channel 400. In an even more sophisticated implementation, the parameter-processing unit 352 could also take into account center channel information to supply an individual ICC value for parameter set 5 and parameter set 4 (410a, 410b).

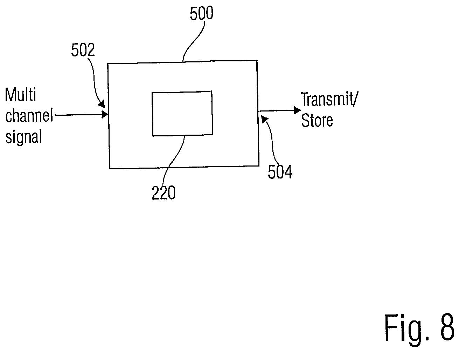

Fig. 8 is showing an inventive audio transmitter or recorder 500 that is having an encoder 220, an input interface 502 and an output interface 504.

An audio signal can be supplied at the input interface 502 of the transmitter/recorder 500. The audio signal is encoded using an inventive encoder 220 within the transmitter/recorder and the encoded representation is output at the output interface 504 of the transmitter/recorder 500. The encoded representation may then be transmitted or stored on a storage medium.

Fig. 9 shows an inventive receiver or audio player 520, having an inventive decoder 312, a bit stream input 522, and an audio output 524.

A bit stream can be input at the input 522 of the inventive receiver/audio player 520. The bit stream then is decoded using the decoder 312 and the decoded signal is output or played at the output 524 of the inventive receiver/audio player 520.

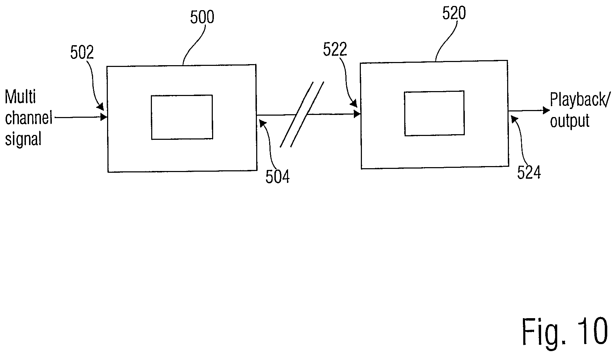

Fig. 10 shows a transmission system comprising an inventive transmitter 500, and an inventive receiver 520.

The audio signal input at the input interface 502 of the transmitter 500 is encoded and transferred from the output 504 of the transmitter 500 to the input 522 of the receiver 520. The receiver decodes the audio signal and plays back or outputs the audio signal on its output 524.

The discussed examples of inventive decoders downmix a multi-channel audio signal into a monophonic audio signal. It is of course alternatively possible to downmix a multi-channel signal into a stereophonic signal, which would for example mean for the embodiments discussed in Figs. 2 and 4, that one step in the hierarchical encoding process could be by-passed. All other numbers of resulting channels are also possible.

The proposed method to hierarchically encode or decode multi-channel audio information providing/using a compact parametric representation of the spatial properties of the audio signal is described mainly by shrinking the side information by combining multiple ICC values into one single transmitted ICC value. It is to note here that the described invention is in no way limited to the use of just one combined ICC value. Instead, e.g., two combined values can be generated, one describing the important left/right correlation, the other one describing a front/back correlation.

This can advantageously be implemented, for example, in the embodiment of the current invention shown in Fig. 2, where on the one hand a left front channel 250a and a left rear channel 250b is combined into a left master channel 254a, and where a right front channel 250c and a right rear channel 250d is combined into a rear master channel 254b. These two encoding steps therefore yield information about the front back correlation of the original audio signal, which can easily be processed to provide an additional ICC value, holding front/back correlation information.

Furthermore, in a preferred modification of the current invention, it is advantageous to have encoding/decoding processes, which can do both, use the prior art individually transmitted parameters, and, depending on a signaling side information that is sent from encoder to decoder, also use combined transmitted parameters. Such a system can advantageously achieve both, higher representation accuracy (using individually transmitted parameters) and, alternatively, a low side information bit rate (using combined parameters).

Typically, the choice of this setting is made by the user depending on the application requirements, such as the amount of side information that can be accommodated by the transmission system used. This allows to use the same unified encoder/decoder architecture while being able to operate within a wide range of side information bit rate/precision trade-offs. This is an important capability in order to cover a wide range of possible applications with differing requirements and transmission capacity.

In another modification of such an advantageous embodiment, the choice of the operating mode could also be made automatically by the encoder, which analyses for example the deviation of the decoded values from the ideal result in case the combined transmission mode was used. If no significant deviation is found, then combined parameter transmission is employed. A decoder could even decide himself, based on an analysis of the provided side information, which mode is the appropriate one to use. For example, if there were just one spatial parameter provided, the decoder would automatically switch into the decoding mode using combined transmitted parameters.

In another advantageous modification of the current invention, the encoder/decoder switches automatically from the mode using combined transmitted parameters to the mode using individually transmitted parameters, to ensure the best possible compromise between an audio reproduction quality and a desired low side information bit rate.

As can be seen from the described preferred embodiments of the encoders/decoders in Figs. 2, 4, 6, and 7, these units make use of the same functional blocks. Therefore, another preferred embodiment builds an encoder and a decoder using the same hardware within one housing.

In an alternative embodiment of the current invention it is possible to dynamically switch between the different encoding schemes by grouping different channels together as channel pairs, making it possible to dynamically use the encoding scheme that provides the best possible audio quality for the given multi-channel audio signal.

It is not necessary to transmit the monophonic downmix channel alongside the parametric representation of a multi-channel audio signal. It is also possible to transmit the parametric representation alone, to enable a listener, who already owns a monophonic downmix of the multi-channel audio signal, for example as a record, to reproduce a multi-channel signal using his existing multi-channel equipment and a parametric side information.

To summarize, the present invention allows to determine these combined parameters advantageously from known prior art parameters. Applying the inventive concept of combining parameters in a hierarchical encoder/decoder structure, one can downmix a multi-channel audio signal into a mono-based parametric representation, obtaining a precise parametrization of the original signal at a low side information rate (= bit-rate reduction).

It is one objective of the present invention that the encoder combines certain parameters with the objective of reducing the number of parameters that have to be transmitted. Then, the decoder derives the missing parameters from parameters that have been transmitted, instead of using default parameter values, as it is the case in systems of prior art, for example the one being shown in Fig. 15.

This advantage becomes evident reviewing again the embodiment of a hierarchical parametric multi-channel audio coder using prior art techniques, an example shown in Fig. 15. There, the input signals (Lf, Rf, Lr, Rr, C and LFE, corresponding to the left front, right front, left rear, right rear, center and low frequency enhancement channels, respectively) are segmented and transformed to the frequency domain to obtain the required time/frequency tiles. The resulting signals are subsequently combined in a pair-wise fashion. For example, the signals Lf and Lr are combined to form signal "L". A corresponding spatial parameter set (1) is generated to model the spatial properties between the signals Lf and Lr (i.e. consisting of one or more of IIDs, ICCs, IPDs). In the embodiment according to the prior art shown in Fig. 15, this process is repeated until a single output channel (M) is obtained, the output channel being accompanied by five parameter sets. The application of prior art hierarchical coding techniques would then imply the transmission of all parameter sets.

It should be noted, however, that not all parameter sets have to contain values for all possible spatial parameters. For example, parameter set 1 in Fig. 15 may consist of IID and ICC parameters, while parameter set 3 may consist of IDD parameters only. If certain parameters are not transmitted for specific sets, the prior art hierarchical decoder will apply a default value for these parameters (for example ICC = + 1, IPD = 0, etc.). Thus, each parameter set represents a specific signal combination only and does not describe spatial properties of the remaining channel pairs.

This loss of knowledge about the spatial properties of signals, who's parameters are not being transmitted, can be avoided using the inventive concept, in which the encoder is combining specific parameters such that the most important spatial properties of the original signal are preserved.

When, for example, ICC parameters are combined into a single value, the combined parameters can be used in the decoder as a substitute for all individual parameters (or the individual parameter used in the decoder can be derived from the transmitted ones). It is an important feature that the encoder parameter combination process is carried out such that the sound image of the original multi-channel signal is preserved as closely as possible after reconstruction by the decoder. Transmitting ICC parameters, this means that the width (decorrelation) of the original sound field should be retained.

It is to be noted here that the most important ICC value is between the left/right axis since the listener usually is facing forward in the listening set-up. This can be taken into account advantageously to build the hierarchical encoding structure such that a suitable parametric representation of the audio signal can be obtained during the iterative encoding process, wherein the resulting combined ICC value represents mainly the left/right decorrelation. This will be explained in more detail later when discussing preferred embodiments of the current invention.

The inventive encoding/decoding scheme allows to reduce the number of transmitted parameters from a encoder to a decoder using a hierarchical structure of a spatial audio system by means of the two following measures:

• combining the individual encoder parameters to form a combined parameter, which is transmitted to the decoder instead of individual ones. The combination of the parameters is carried out such that the signal sound image (including L/R correlation/coherence) is preserved as far as possible.

• the transmitted combined parameter is used in the decoder instead of several transmitted individual parameters (or the actually used parameters are derived from the combined one).

Depending on certain implementation requirements of the inventive methods, the inventive methods can be implemented in hardware or in software. The implementation can be performed using a digital storage medium, in particular a disk, DVD or a CD having electronically readable control signals stored thereon, which cooperate with a programmable computer system such that the inventive methods are performed. Generally, the present invention is, therefore, a computer program product with a program code stored on a machine readable carrier, the program code being operative for performing the inventive methods when the computer program product runs on a computer. In other words, the inventive methods are, therefore, a computer program having a program code for performing at least one of the inventive methods when the computer program runs on a computer.

**Claims**

1. Encoder for generating a parametric representation (238) of an audio signal having at least two original left channels (224a, 224b) on a left side and two original right channels (224c, 224d) on a right side with respect to a listening position, comprising:

    a generator (220) for generating parametric information, the generator (220) being operative to separately process several pairs of channels to derive a level information (230a, 230b, 234) for processed channel pairs, and to derive coherence information (236) for a channel pair including a first channel (228a; 224a, 224b) only having information from the left side and a second channel (228b; 224c, 224d) only having information from the right side; and
    a provider (222) for providing the parametric representation (238) by selecting the level information (230a, 230b, 234) for channel pairs and by determining a left/right coherence measure using the coherence information (236) and to introduce the left/right coherence measure into an output datastream as the only coherence information of the audio signal within the parametric representation (238).

2. Encoder in accordance with claim 1, in which the generator (220) is operative

    to process (242a) a left-front channel lf and a left-rear channel lr to derive a lf/lr level information, wherein a combination of the left-front channel lf and the left-rear lr channel forms a left master channel LM, and to process (242b) a right-front channel rf and a right-rear channel rr to derive a rf/rr level information, wherein a combination of the right-front channel rf and the right-rear rr channel forms a right master channel RM; and
    to process (242d) the left master channel LM and the right master channel RM to derive a lm/rm level information and to derive the coherence information (236), wherein a combination of the left master channel LM and the right master channel RM forms a stereo master channel SM.

3. Encoder in accordance with claim 2, in which the generator (220) is operative to process (242c) a center channel ce and a low-frequency channel lo to derive a ce/lo level information, wherein a combination of the center channel ce and the low-frequency channel lo forms a center master channel CM.

4. Encoder in accordance with claim 3,
    in which the generator (220) is operative to process (242e) the stereo master channel SM and the center master channel CM to derive a sm/cm level information, wherein a combination of the stereo master channel SM and the center master CM channel forms a downmix channel (274); and
    in which the provider (222) is operative to determine the left/right coherence measure using the coherence information (236) and the sm/cm level information.

5. Encoder in accordance with claim 4, in which the provider (222) is operative to calculate (244) the left/right coherence measure depending on the sm/cm level information such that, in a case, in which the sm/cm level information indicates, that more energy is in the stereo master channel SM than in the center master channel CM, the left/right coherence measure is more close to the coherence information compared to a situation, in which the sm/cm level information indicates, that more energy is in the center master channel CM, in which case the left/right coherence measure is more close to unity.

6.  Encoder in accordance with claim 4, in which the provider (222) is operative to calculate (244) the left/right coherence measure depending on the sm/cm level information such that, in a case, in which the sm/cm level information indicates, that a ratio of the energy in the stereo master channel SM and the energy in the center master channel CM exceeds a predefined value, the left/right coherence measure is set to the coherence information compared to a situation, in which the sm/cm level information indicates, that the ratio of the energy in the stereo master channel SM to the energy in the center master channel CM stays below or equals the predefined value, in which the left/right coherence measure is set to unity.

7.  Encoder in accordance with claim 1, in which the generator (220) is operative to process (242a) a left-front channel lf and a right-front channel rf to derive a lf/rf level information and a first coherence information (302a), wherein a combination of the left-front channel lf and the right-front channel rf forms a front master channel FM, and to process (242c) a left-rear channel lr and a right-rear channel rr to derive a lr/rr level information and to derive a second coherence information (302b), wherein a combination of the left-rear channel lr and the right-rear channel rr forms a rear master channel RM, and in which the provider (222) is operative to determine the left/right coherence measure combining the first coherence information (302a) and the second coherence information (302b).

8.  Encoder in accordance with claim 7, in which the provider (222) is operative to determine the left/right coherence measure based on a weighted sum of the first and the second coherence information (302a, 302b), using level information of the front master channel FM and level information of the rear master channel RM as weights.

9.  Encoder in accordance with claim 7, in which the generator (220) is operative to process (242c) a center channel ce and a low-frequency channel lo to derive a ce/lo level information, wherein a combination of the center channel ce and the low-frequency channel lo forms a center master channel CM.

10. Encoder in accordance with claim 9, in which the generator (220) is operative to process (242d) the front master channel FM and the center master channel CM to derive a fm/cm level information, wherein a combination of the front master channel FM and the center master channel CM forms a pure front channel PF; and in which the provider (222) is operative to determine the left/right coherence measure combining the first and the second coherence information (302a, 302b) additionally using the fm/cm level information.

11. Encoder in accordance with claim 11, in which the generator (220) is operative to process (242e) the pure front channel PF and the rear master channel RM to derive a pf/rm level information, wherein a combination of the pure front channel PF and the rear master channel RM forms a downmix channel.

12. Encoder in accordance with claim 1, in which the generator (220) is operative to process the pairs of channels in discrete time frames of a given length.

13. Encoder in accordance with claim 1 in which the generator (220) is operative to process the pairs of channels in discrete frequency intervals of a given bandwidth.

14. Decoder for processing a parametric representation (314, 316, 318, 320) of an original audio signal, the original audio signal having at least two original left channels (324b, 324d; 360a, 360b) on a left side and at least two original right channels (324a, 324d; 360c, 360d) on a right side with respect to a listening position, comprising:

    a receiver (310) for providing the parametric representation (314, 316, 318, 320) of the audio signal, the receiver (310) being operative to provide level information (314, 316, 318) for channel pairs and to provide a left/right coherence measure (320) for a channel pair including a left channel and a right channel as the only coherence information of the original audio signal within the parametric representation (314, 316, 318, 320), the left/right coherence measure (320) representing a coherence information between at least one channel pair including a first channel only having information from the left side and a second channel only having information from the right side; and
    a processor (312) for supplying parametric information for channel pairs, the processor (312) being operative to select level information (314, 316, 318) from the parametric representation (314, 316, 318, 320) and to derive coherence information for at least one channel pair using the left/right coherence measure (320), the at least one channel pair including a first channel (324b, 324d) only having information from the left side and a second channel (324a, 324c) only having information from the right side.

15. Decoder in accordance with claim 14, in which the receiver (310) is operative to

provide a lf/lr level information (380a) for a channel pair of an original left-front channel lf and an original left-rear channel lr, wherein a combination of the original left-front channel lf and the original left-rear channel lr forms a left master channel LM;
provide a rf/rr level information (380b) for a channel pair of an original right-front channel rf and an original right-rear channel rr, wherein a combination of the original right-front channel rf and the original right-rear channel rr forms an right master channel RM;
provide a lm/rm level information (380d) for a channel pair of the left master channel LM and the right master channel RM, wherein a combination of the left master channel LM and the right master channel RM forms a stereo master channel SM; and

in which the processor (312) is operative to provide (352) coherence information for the left master channel LM and the right master channel RM using the left/right coherence measure (320);
the decoder further comprising an upmixer, the upmixer having :

a first 1-to-2 upmixer (354b) for generation of the left master channel LM and the right master channel RM from the stereo master channel SM using the lm/rm level information (380d) and the left/right coherence measure (320);
a second 1-to-2 upmixer (354e) for generation of the original left-front channel lf (360a) and the original left-rear channel lr (360b) from the left master channel LM using the lf/lr level information (380a) and a predefined coherence information; and
a third 1-to-2 upmixer (354d) for generation of the original right-front rf channel (360c) and the original right-rear channel rr (360d) from the right master channel RM using the rf/rr level information (380b) and a predefined coherence information.

16. Decoder in accordance with claim 15, in which the receiver (310) is operative to provide a ce/lo level information (380c) for a channel pair of an original center channel ce and of an original low-frequency channel lo, wherein a combination of the original center channel ce and of the original low-frequency channel lo forms a center master channel CM; and
in which the upmixer is further comprising a fourth 1-to-2 upmixer (354c) for generation of the original center channel ce (360e) and the original low-frequency channel lo (360f) from the center master channel CM using the ce/lo level information (380c) and a predefined coherence information.

17. Decoder in accordance with claim 16, in which the receiver (310) is operative to provide a sm/cm level information (380e) for a channel pair of the stereo master channel SM and of the center master channel CM, wherein a combination of the stereo master channel SM and of the center master channel CM forms a downmix channel; and
in which the upmixer is further comprising a fifth 1-to-2 upmixer (354a) for generation of the stereo master channel SM and the center master channel CM from the downmix channel using the sm/cm level information (380e) and a predefined coherence information.

18. Decoder in accordance with claim 14, in which the receiver (310) is operative to

provide a lf/rf level information (410a) for a channel pair of an original left-front channel lf and of an original right-front channel rf, wherein a combination of the original left-front channel lf and of the original right-front channel rf forms a front master channel FM;
provide a lr/rr level information (410c) for a channel pair of an original left-rear channel lr and an original right-rear channel rr, wherein a combination of the original left-rear channel lr and the original right-rear channel rr forms a rear master channel RM; and

in which the processor (312) is operative to supply a first coherence information for the original left-front channel lf and the original right-front channel rf and to supply a second coherence information for the original left-rear channel lr and the original right-rear channel rr using the left/right coherence measure (320);
the decoder further comprising an upmixer, the upmixer having :

a first 1-to-2 upmixer (354e) for generation of the original left-front channel lf (360a) and the original right-front channel rf (360c) from the front master channel FM using the lf/rf level information (410a) and the left/right coherence measure (320);
a second 1-to-2 upmixer (354c) for generation of the original left-rear channel lr (360b) and the original right-rear channel rr (360d) from the rear master RM channel using the lr/rr level information (410c) and the left/right coherence measure (320).

19. Decoder in accordance with claim 18, in which the receiver (310) is operative to provide a ce/lo level information (410b) for a channel pair of an original center channel ce and of an original low-frequency channel lo, wherein a combination of the original center channel ce and of the original low-frequency channel lo forms a center master channel CM; and in which the upmixer is further comprising a third 1-to-2 upmixer (354d) for generation of the original center channel co (360e) and the original low-frequency channel lo (360f) from the center master channel CM using the ce/lo level information (410b) and a predefined coherence information.

20. Decoder in accordance with claim 19, in which the receiver (310) is operative to provide a fm/cm level information (410b) for a channel pair of the front master channel FM and the center master channel CM, wherein a combination of the front master channel FM and the center master channel CM forms a pure front channel PF; and in which the upmixer is further comprising a fourth 1-to-2 upmixer (354b) for generation of the front master channel FM and the center master channel CM from the pure front channel PF using the fm/cm level information (410b) and a predefined coherence information.

21. Decoder in accordance with claim 20, in which the receiver (310) is operative to provide a pf/rm level information (410a) for a channel pair of the pure front channel PF and the rear master channel RM, wherein a combination of the pure front channel PF and the rear master channel RM forms a downmix channel; and in which the upmixer is further comprising a fifth 1-to-2 upmixer (354a) for generation of the pure front channel PF and the rear master channel RM from the downmix channel using the pf/rm level information (410a) and a predefined coherence information.

22. Decoder in accordance with claim 14, in which the processor (312) is operative to derive coherence measures for all channel pairs by distributing the received left/right coherence measure (320) as the coherence measures.

23. Decoder in accordance with claim 14, in which the receiver (310) is operative to

operate in a first mode, providing level information (314, 316, 318) for channel pairs and providing a left/right coherence measure (320) for a channel pair including a left channel and a right channel as the only coherence information of the audio signal within the parametric representation (314, 316, 318, 320), the left/right coherence measure (320) representing a coherence information between at least one channel pair including a first channel only having information from the left side and a second channel only having information from the right side with respect to a listening position; or to operate in a second mode, providing the level information (314, 316, 318) for channel pairs and the coherence information for the same channel pairs; and

in which the processor (312) is operative to supply parametric information for channel pairs

in the first mode, the processor (312) being operative to select the level information (314, 316, 318) from the parametric representation (314, 316, 318, 320) and to derive the coherence information for at least one channel pair using the left/right coherence measure (320), the at least one channel pair including a first channel only having information from the left side and a second channel only having information from the right side; or in the second mode, the processor (312) being operative to select the level information (314, 316, 318) from the parametric representation (314, 316, 318, 320) and to select the coherence information from the parametric representation (314, 316, 318, 320).

24. Decoder in accordance with claim 23, in which the receiver (310) further comprises a mode receiver for selecting an operating mode using received mode information, the mode information indicating the first or the second mode to be used.

25. A method for generating a parametric representation (238) of an audio signal having at least two original left channels (224a, 224b) and at least two original right channels (224c, 224c) with respect to a listening position, the method comprising:

generating parametric information by separately processing several pairs of channels to derive a level information (230a, 230b, 234) for processed channel pairs and by deriving coherence information (236) for a channel pair including a first channel (228a; 224a, 224b) only having information from the left side and a second channel (228b; 224c, 224d) only having information from the right side, and

providing the parametric representation (238) by selecting level information (230a, 230b, 234) for travel pairs and by determining a left/right coherence measure using the coherence information (236) and introducing the left/right coherence measure into an output datastream as the only coherence information (236) of the audio signal within the parametric representation (238).

26. A method for processing a parametric representation (314, 316, 318, 320) of an original audio signal, the original audio signal having at least two original left channels (324b, 324d; 360a, 360b) on the left side and at least two original right channels (324a, 324d; 360c, 360d) on the right side with respect to a listening position, the method comprising:

providing the parametric representation (314, 316, 318, 320) of the audio signal by providing a level information (314, 316, 318) for channel pairs and by providing a left/right coherence measure (320) for a channel pair including a left channel and a right channel as the only coherence information of the original audio signal within the parametric representation (314, 316, 318, 320), the left/right coherence measure (320) representing a coherence information between at least one channel pair including a first channel only having information from the left side and a second channel only having information from the right side; and

supplying parametric information for channel pairs by selecting level information (314, 316, 318) from the parametric representation (314, 316, 318, 320) and by deriving coherence information for at least one channel pair using the left/right coherence measure (320), the at least one channel pair including a first channel (324b, 324d) only having information from the left side and a second channel (324a, 324c) only having information from the right side.

27. Encoded audio data with side information, the side information comprising a parametric representation (314, 316, 318, 320) of an audio signal having at least two original left channels (324b, 324d; 360a, 360b) on a left side and two original right channels (324a, 324d; 360c, 360d) on a right side with respect to a listening position, wherein the parametric representation (314, 316, 318, 320) comprises level differences (314, 316, 318) for channel pairs and a left/right coherence measure (320) derived from coherence information from a channel pair including a first channel only having information from the left side and a second channel only having information from the right side, as the only coherence information of the original audio signal within the parametric representation.

28. Computer readable storage medium, having stored thereon encoded audio data in accordance with claim 27.

29. Receiver (520) or audio player having a decoder (312) in accordance with claim 14.

30. Transmitter (500) or audio recorder having an encoder (220) in accordance with claim 1.

31. Method of receiving or audio playing, the method having a method for processing in accordance with claim 26.

32. Method of transmitting or audio recording, the method having a method for generating in accordance with claim 25.

33. Transmission system having a transmitter (500) and a receiver (520),
wherein the transmitter (500) has an encoder (220) in accordance with claim 1, and
wherein the receiver (520) has a decoder (312) in accordance with claim 14.

34. Method of transmitting and receiving,
wherein the method of transmitting has a method for generating in accordance with claim 25, and
wherein the method of receiving has a method for processing in accordance with claim 26.

35. Computer having a program code for performing, when running on a computer, any one of the methods of claims 25, 26, 31, 32, or 34.

**Patentansprüche**

1. Codierer zum Erzeugen einer parametrischen Darstellung (238) eines Audiosignals mit mindestens zwei linken Originalkanälen (224a, 224b) auf einer linken Seite und zwei rechten Originalkanälen (224c, 224d) auf einer rechten Seite in Bezug auf eine Hörposition, umfassend:

einen Generator (220) zum Erzeugen parametrischer Information, wobei der Generator (220) betriebsfähig ist, um mehrere Kanalpaare separat zu verarbeiten, um eine Pegelinformation (230a, 230b, 234) für verarbeitete Kanalpaare abzuleiten und um Kohärenzinformation (236) für ein Kanalpaar abzuleiten, das einen ersten Kanal (228a; 224a, 224b) mit nur Information von der linken Seite und einen zweiten Kanal (228b; 224c, 224d) mit nur Information von der rechten Seite einschließt; und

eine Bereitstellungseinheit (222) zum Bereitstellen der parametrischen Darstellung (238) durch Auswählen der Pegelinformation (230a, 230b, 234) für Kanalpaare und durch Ermitteln eines Links/Rechts-Kohärenzmaßes unter Verwendung der Kohärenzinformation (236) und zum Einführen des Links/Rechts-Kohärenzmaßes in einen Ausgangsdatenstrom als die einzige Kohärenzinformation des Audiosignals innerhalb der parametrischen Darstellung (238).

2. Codierer nach Anspruch 1, in dem der Generator (220) betriebsfähig ist
zum Verarbeiten (242a) eines linken-vorderen Kanals lf und eines linken-hinteren Kanals 1r, um eine lf/lr-Pegelinformation abzuleiten, wobei eine Kombination des linken-vorderen Kanals lf und des linken-hinteren Kanals lr einen linken Masterkanal LM ergibt, und zum Verarbeiten (242b) eines rechten-vorderen Kanals rf und eines rechten-hinteren Kanals rr, um eine rf/rr-Pegelinformation abzuleiten, wobei eine Kombination des rechten-vorderen Kanals rf und des rechten-hinteren Kanals rr einen rechten Masterkanal RM ergibt; und
zum Verarbeiten (242d) des linken Masterkanals LM und des rechten Masterkanals RM, um eine lm/rm-Pegelinformation abzuleiten und um die Kohärenzinformation (236) abzuleiten, wobei eine Kombination des linken Masterkanals LM und des rechten Masterkanals RM einen Stereo-Masterkanal SM ergibt.

3. Codierer nach Anspruch 2, in dem der Generator (220) betriebsfähig ist, um einen mittleren Kanal ce und einen niederfrequenten Kanal lo zu verarbeiten (242c), um eine ce/lo-Pegelinformation abzuleiten, wobei eine Kombination des mittleren Kanals ce und des niederfrequenten Kanals lo einen mittleren Masterkanal CM ergibt.

4. Codierer nach Anspruch 3,
in dem der Generator (220) betriebsfähig ist, um den Stereo-Masterkanal SM und den mittleren Masterkanal CM zu verarbeiten (242e), um eine sm/cm-Pegelinformation abzuleiten, wobei eine Kombination des Stereo-Masterkanals SM und des mittleren Masterkanals CM einen Downmix-Kanal (274) ergibt; und
in dem die Bereitstellungseinheit (22) betriebsfähig ist, um das Links/Rechts-Kohärenzmaß unter Verwendung der Kohärenzinformation (236) und der sm/cm-Pegelinformation zu ermitteln.

5. Codierer nach Anspruch 4, in dem die Bereitstellungseinheit (222) betriebsfähig ist, um das Links/Rechts-Kohärenzmaß abhängig von der sm/cm-Pegelinformation derartig zu berechnen (244), dass in dem Fall, in dem die sm/cm-Pegelinformation angibt, dass mehr Energie in dem Stereo-Masterkanal SM vorhanden ist als in dem mittleren Masterkanal CM, das Links/Rechts-Kohärenzmaß näher bei der Kohärenzinformation liegt als in einer Situation, in der die sm/cm-Pegelinformation angibt, dass mehr Energie in dem mittleren Masterkanal CM vorhanden ist, in welchem Fall das Links/Rechts-Kohärenzmaß näher bei Eins liegt.

6. Codierer nach Anspruch 4, in dem die Bereitstellungseinheit (222) betriebsfähig ist, um das Links/Rechts-Kohärenzmaß abhängig von der sm/cm-Pegelinformation derartig zu berechnen (244), dass in dem Fall, in dem die sm/cm-Pegelinformation angibt, dass ein Verhältnis der Energie in dem Stereo-Masterkanal SM und der Energie in dem mittleren Masterkanal CM einen vorgegebenen Wert überschreitet, das Links/Rechts-Kohärenzmaß auf die Kohärenzinformation eingestellt wird, während in einer Situation, in der die sm/cm-Pegelinformation angibt, dass das Verhältnis der Energie in dem Stereo-Masterkanal SM zu der Energie in dem mittleren Masterkanal CM unter oder gleich dem vorgegebenen Wert bleibt, das Links/Rechts-Kohärenzmaß auf Eins eingestellt wird.

7. Codierer nach Anspruch 1,
in dem der Generator (220) betriebsfähig ist, um einen linken-vorderen Kanal lf und einen rechten-vorderen Kanal rf zu verarbeiten (242a), um eine lf/rf-Pegelinformation und eine erste Kohärenzinformation (302a) abzuleiten, wobei eine Kombination des linken-vorderen Kanals lf und des rechten-vorderen Kanals rf einen vorderen Masterkanal FM ergibt, und um einen linken-hinteren Kanal lr und einen rechten-hinteren Kanal rr zu verarbeiten (242c), um eine lr/rr-Pegelinformation abzuleiten und um eine zweite Kohärenzinformation (302b) abzuleiten, wobei eine Kombination des linken-hinteren Kanals lr und des rechten-hinteren Kanals rr einen hinteren Masterkanal RM ergibt; und
in dem die Bereitstellungseinheit (222) betriebsfähig ist, um das Links/Rechts-Kohärenzmaß zu ermitteln, indem sie die erste Kohärenzinformation (302a) und die zweite Kohärenzinformation (302b) kombiniert.

8. Codierer nach Anspruch 7, in dem die Bereitstellungseinheit (222) betriebsfähig ist, um das Links/Rechts-Kohärenzmaß basierend auf einer gewichteten Summe der ersten und der zweiten Kohärenzinformation (302a, 302b) unter Verwendung von Pegelinformation des vorderen Masterkanals FM und Pegelinformation des hinteren Masterkanals RM als Gewichte zu ermitteln.

9. Codierer nach Anspruch 7, in dem der Generator (220) betriebsfähig ist, um einen mittleren Kanal ce und einen niederfrequenten Kanal lo zu verarbeiten (242c), um eine ce/lo-Pegelinformation abzuleiten, wobei eine Kombination des mittleren Kanals ce und des niederfrequenten Kanals lo einen mittleren Masterkanal CM ergibt.

10. Codierer nach Anspruch 9, in dem der Generator (220) betriebsfähig ist, um den vorderen Masterkanal FM und den mittleren Masterkanal CM zu verarbeiten (242d), um eine fm/cm-Pegelinformation abzuleiten, wobei eine Kombination des vorderen Masterkanals FM und des mittleren Masterkanals CM einen reinen vorderen Kanal PF ergibt; und in dem die Bereitstellungseinheit (222) betriebsfähig ist, um das Links/Rechts-Kohärenzmaß zu ermitteln, indem sie die erste und die zweite Kohärenzinformation (302a, 302b) kombiniert, wobei sie zusätzlich die fm/cm-Pegelinformation verwendet.

11. Codierer nach Anspruch 11, in dem der Generator (220) betriebsfähig ist, um den reinen vorderen Kanal PF und den hinteren Masterkanal RM zu verarbeiten (242e), um eine pf/rm-Pegelinformation abzuleiten, wobei eine Kombination des reinen vorderen Kanals PF und des hinteren Masterkanals RM einen Downmix-Kanal ergibt.

12. Codierer nach Anspruch 1, in dem der Generator (220) betriebsfähig ist, um die Kanalpaare in diskreten Zeitrahmen einer gegebenen Länge zu verarbeiten.

13. Codierer nach Anspruch 1, in dem der Generator (220) betriebsfähig ist, um die Kanalpaare in diskreten Zeitintervallen einer gegebenen Bandbreite zu verarbeiten.

14. Decodierer zum Verarbeiten einer parametrischen Darstellung (314, 316, 318, 320) eines Original-Audiosignals, wobei das Original-Audiosignal mindestens zwei linke Originalkanäle (324b, 324d; 360a, 360b) auf einer linken Seite und mindestens zwei rechte Originalkanäle (324a, 324d; 360c, 360d) auf einer rechten Seite in Bezug auf eine Hörposition aufweist, umfassend:

einen Empfänger (310) zum Bereitstellen der parametrischen Darstellung (314, 316, 318, 320) des Audiosignals, wobei der Empfänger (310) betriebsfähig ist, um Pegelinformation (314, 316, 318) für Kanalpaare bereitzustellen und um ein Links/Rechts-Kohärenzmaß (320) für ein Kanalpaar umfassend einen linken Kanal und einen rechten Kanal als die einzige Kohärenzinformation des Original-Audiosignals innerhalb der parametrischen Darstellung (314, 316, 318, 320) bereitzustellen, wobei das Links/Rechts-Kohärenzmaß (320) eine Kohärenzinformation zwischen mindestens einem Kanalpaar umfassend einen ersten Kanal mit nur Information von der linken Seite und einen zweiten Kanal mit nur Information von der rechten Seite darstellt; und einen Prozessor (312) zum Liefern von parametrischer Information für Kanalpaare, wobei der Prozessor (312) betriebsfähig ist, um Pegelinformation (314, 316, 318) aus der parametrischen Darstellung (314, 316, 318, 320) auszuwählen und um Kohärenzinformation für mindestens ein Kanalpaar unter Verwendung des Links/Rechts-Kohärenzmaßes (320) abzuleiten, wobei das mindestens eine Kanalpaar einen ersten Kanal (324b, 324d) mit nur Information von der linken Seite und einen zweiten Kanal (324a, 324c) mit nur Information von der rechten Seite umfasst.

15. Decodierer nach Anspruch 14, in dem der Empfänger (310) betriebsfähig ist zum

Bereitstellen einer lf/lr-Pegelinformation (380a) für ein Kanalpaar aus einem linken-vorderen Originalkanal lf und einem linken-hinteren Originalkanal lr, wobei eine Kombination des linken-vorderen Originalkanals lf und des linken-hinteren Originalkanals lr einen linken Masterkanal LM ergibt; Bereitstellen einer rf/rr-Pegelinformation (380b) für ein Kanalpaar aus einem rechten-vorderen Originalkanal rf und einem rechten-hinteren Originalkanal rr, wobei eine Kombination des rechten-vorderen Originalkanals rf und des rechten-hinteren Originalkanals rr einen rechten Masterkanal RM ergibt; Bereitstellen einer lm/rm-Pegelinformation (380d) für ein Kanalpaar aus dem linken Masterkanal LM und dem rechten Masterkanal RM, wobei eine Kombination des linken Masterkanals LM und des rechten Masterkanals RM einen Stereo-Masterkanal SM ergibt; und

in dem der Prozessor (312) betriebsfähig ist, um Kohärenzinformation für den linken Masterkanal LM und den rechten Masterkanal RM unter Verwendung des Links/Rechts-Kohärenzmaßes (320) bereitzustellen (352); wobei der Decodierer ferner einen Upmixer umfasst, wobei der Upmixer Folgendes aufweist:

einen ersten 1-zu-2-Upmixer (354b) zum Erzeugen des linken Masterkanals LM und des rechten Masterkanals RM anhand des Stereo-Masterkanals SM unter Verwendung der lm/rm-Pegelinformation (380d) und des Links/Rechts-Kohärenzmaßes (320); einen zweiten 1-zu-2-Upmixer (354e) zum Erzeugen des linken-vorderen Originalkanals lf (360a) und des linken-hinteren Originalkanals lr (360b) anhand des linken Masterkanals LM unter Verwendung der lf/lr-Pegelinformation (380a) und einer vordefinierten Kohärenzinformation; und

einen dritten 1-zu-2-Upmixer (354d) zum Erzeugen des rechten-vorderen Originalkanals rf (360c) und des rechten-hinteren Originalkanals rr (360d) anhand des rechten Masterkanals RM unter Verwendung der rf/rr-Pegelinformation (380b) und einer vordefinierten Kohärenzinformation.

16. Decodierer nach Anspruch 15,
in dem der Empfänger (310) betriebsfähig ist, um eine ce/lo-Pegelinformation (380c) für ein Kanalpaar aus einem mittleren Originalkanal ce und einem niederfrequenten Originalkanal lo bereitzustellen, wobei eine Kombination des mittleren Originalkanals ce und des niederfrequenten Originalkanals lo einen mittleren Masterkanal CM ergibt; und
in dem der Upmixer ferner einen vierten 1-zu-2-Upmixer (354c) zum Erzeugen des mittleren Originalkanals ce (360e) und des niederfrequenten Originalkanals lo (360f) anhand des mittleren Masterkanals CM unter Verwendung der ce/lo-Pegelinformation (380c) und einer vordefinierten Kohärenzinformation umfasst.

17. Decodierer nach Anspruch 16,
in dem der Empfänger (310) betriebsfähig ist, um eine sm/cm-Pegelinformation (380e) für ein Kanalpaar aus dem Stereo-Masterkanal SM und aus dem mittleren Masterkanal CM bereitzustellen, wobei eine Kombination des Stereo-Masterkanals SM und des mittleren Masterkanals CM einen Downmix-Kanal ergibt; und
in dem der Upmixer ferner einen fünften 1-zu-2-Upmixer (354a) zum Erzeugen des Stereo-Masterkanals SM und des mittleren Masterkanals CM anhand des Downmix-Kanals unter Verwendung der sm/cm-Pegelinformation (380e) und einer vordefinierten Kohärenzinformation umfasst.

18. Decodierer nach Anspruch 14, in dem der Empfänger (310) betriebsfähig ist zum

Bereitstellen einer lf/rf-Pegelinformation (410a) für ein Kanalpaar aus einem linken-vorderen Originalkanal lf und einem rechten-vorderen Originalkanal rf, wobei eine Kombination des linken-vorderen Originalkanals lf und des rechten-vorderen Originalkanals rf einen vorderen Masterkanal FM ergibt;
Bereitstellen einer lr/rr-Pegelinformation (410c) für ein Kanalpaar aus einem linken-hinteren Originalkanal lr und einem rechten-hinteren Originalkanal rr, wobei eine Kombination des linken-hinteren Originalkanals lr und des rechten-hinteren Originalkanals rr einen hinteren Masterkanal RM ergibt; und

in dem der Prozessor (312) betriebsfähig ist, um eine erste Kohärenzinformation für den linken-vorderen Originalkanal lf und den rechten-vorderen Originalkanal rf zu liefern und um eine zweite Kohärenzinformation für den linken-hinteren Originalkanal lr und den rechten-hinteren Originalkanal rr unter Verwendung des Links/Rechts-Kohärenzmaßes (320) zu liefern;
wobei der Decodierer ferner einen Upmixer umfasst, wobei der Upmixer Folgendes aufweist:

einen ersten 1-zu-2-Upmixer (354e) zum Erzeugen des linken-vorderen Originalkanals lf (360a) und des rechten-vorderen Originalkanals lr (360c) anhand des vorderen Masterkanals FM unter Verwendung der lf/rf-Pegelinformation (410a) und des Links/Rechts-Kohärenzmaßes (320);
einen zweiten 1-zu-2-Upmixer (354c) zum Erzeugen des linken-hinteren Originalkanals lr (360b) und des rechten-hinteren Originalkanals rr (360d) anhand des hinteren Masterkanals RM unter Verwendung der lr/rr-Pegelinformation (410c) und des Links/Rechts-Kohärenzmaßes (320).

19. Decodierer nach Anspruch 18,
in dem der Empfänger (310) betriebsfähig ist, um eine ce/lo-Pegelinformation (410b) für ein Kanalpaar aus einem mittleren Originalkanal ce und einem niederfrequenten Originalkanal lo bereitzustellen, wobei eine Kombination des mittleren Originalkanals ce und des niederfrequenten Originalkanals lo einen mittleren Masterkanal CM ergibt; und
in dem der Upmixer ferner einen dritten 1-zu-2-Upmixer (354d) zum Erzeugen des mittleren Originalkanals ce (360e) und des niederfrequenten Originalkanals lo (360f) anhand des mittleren Masterkanals CM unter Verwendung der ce/lo-Pegelinformation (410b) und einer vordefinierten Kohärenzinformation umfasst.

20. Decodierer nach Anspruch 19,
in dem der Empfänger (310) betriebsfähig ist, um eine fm/cm-Pegelinformation (410b) für ein Kanalpaar aus dem vorderen Masterkanal FM und dem mittleren Masterkanal CM bereitzustellen, wobei eine Kombination des vorderen Masterkanals FM und des mittleren Masterkanals CM einen reinen vorderen Kanal PF ergibt; und
in dem der Upmixer ferner einen vierten 1-zu-2-Upmixer (354b) zum Erzeugen des vorderen Masterkanals FM und des mittleren Masterkanals CM anhand des reinen vorderen Kanals PF unter Verwendung der fm/cm-Pegelinformation (410b) und einer vordefinierten Kohärenzinformation umfasst.

21. Decodierer nach Anspruch 20, in dem der Empfänger (310) betriebsfähig ist, um eine pf/rm-Pegelinformation (410a) für ein Kanalpaar aus dem reinen vorderen Kanal PF und dem hinteren Masterkanal RM bereitzustellen, wobei eine Kombination des reinen vorderen Kanals PF und des hinteren Masterkanals RM einen Downmix-Kanal ergibt; und in dem der Upmixer ferner einen fünften 1-zu-2-Upmixer (354a) zum Erzeugen des reinen vorderen Kanals PF und des hinteren Masterkanals RM anhand des Downmix-Kanals unter Verwendung der pf/rm-Pegelinformation (410a) und einer vordefinierten Kohärenzinformation umfasst.

22. Decodierer nach Anspruch 14, in dem der Prozessor (312) betriebsfähig ist, um Kohärenzmaße für alle Kanalpaare abzuleiten, indem er das empfangene Links/Rechts-Kohärenzmaß (320) als die Kohärenzmaße verteilt.

23. Decodierer nach Anspruch 14, in dem der Empfänger (310) betriebsfähig ist, um

in einem ersten Modus zu arbeiten, in dem er Pegelinformation (314, 316, 318) für Kanalpaare bereitstellt und ein Links/Rechts-Kohärenzmaß (320) für ein Kanalpaar umfassend einen linken Kanal und einen rechten Kanals als die einzige Kohärenzinformation des Audiosignals innerhalb der parametrischen Darstellung (314, 316, 318, 320) bereitstellt, wobei das Links/Rechts-Kohärenzmaß (320) eine Kohärenzinformation zwischen mindestens einem Kanalpaar darstellt, das einen ersten Kanal mit nur Information von der linken Seite und einen zweiten Kanal mit nur Information von der rechten Seite in Bezug auf eine Hörposition umfasst; oder
in einem zweiten Modus zu arbeiten, in dem er Pegelinformation (314, 316, 318) für Kanalpaare und die Kohärenzinformation für die gleichen Kanalpaare bereitstellt; und

in der Prozessor (312) betriebsfähig ist, um parametrische Information für Kanalpaare zu liefern in dem ersten Modus, wobei der Prozessor (312) betriebsfähig ist, um die Pegelinformation (314, 316, 318) aus der parametrischen Darstellung (314, 316, 318, 320) auszuwählen und um die Kohärenzinformation für mindestens ein Kanalpaar unter Verwendung des Links/Rechts-Kohärenzmaßes (320) abzuleiten, wobei das mindestens eine Kanalpaar einen ersten Kanal mit nur Informationen von der linken Seite und einen zweiten Kanal mit nur Informationen von der rechten Seite einschließt; oder
in dem zweiten Modus, wobei der Prozessor (312) betriebsfähig ist, um die Pegelinformation (314, 316, 318) aus der parametrischen Darstellung (314, 316, 318, 320) auszuwählen und um die Kohärenzinformation aus der parametrischen Darstellung (314, 316, 318, 320) auszuwählen.

24. Decodierer nach Anspruch 23, in dem der Empfänger (310) ferner einen Modusempfänger zum Auswählen eines Betriebsmodus unter Verwendung der empfangenen Modusinformation umfasst, wobei die Modusinformation angibt, ob der erste oder der zweite Modus zu verwenden ist.

25. Verfahren zum Erzeugen einer parametrischen Darstellung (238) eines Audiosignals mit mindestens zwei linken Originalkanälen (224a, 224b) und mindestens zwei rechten Originalkanälen (224c, 224d) in Bezug auf eine Hörposition, wobei das Verfahren Folgendes umfasst:

Erzeugen parametrischer Information durch separates Verarbeiten mehrerer Kanalpaare, um eine Pegelinformation (230a, 230b, 234) für verarbeitete Kanalpaare abzuleiten, und durch Ableiten von Kohärenzinformation (236) für ein Kanalpaar, das einen ersten Kanal (228a; 224a, 224b) mit nur Information von der linken Seite und einen zweiten Kanal (228b; 224c, 224d) mit nur Information von der rechten Seite einschließt; und
Bereitstellen der parametrischen Darstellung (238) durch Auswählen der Pegelinformation (230a, 230b, 234) für Kanalpaare und durch Ermitteln eines Links/Rechts-Kohärenzmaßes unter Verwendung der Kohärenzinformation (236) und Einführen des Links/Rechts-Kohärenzmaßes in einen Ausgangsdatenstrom als die einzige Kohärenzinformation (236) des Audiosignals innerhalb der parametrischen Darstellung (238).

26. Verfahren zum Verarbeiten einer parametrischen Darstellung (314, 316, 318, 320) eines Original-Audiosignals, wobei das Original-Audiosignal mindestens zwei linke Originalkanäle (324b, 324d; 360a, 360b) auf der linken Seite und mindestens zwei rechte Originalkanäle (324a, 324d; 360c, 360d) auf der rechten Seite in Bezug auf eine Hörposition aufweist, wobei das Verfahren Folgendes umfasst:

Bereitstellen der parametrischen Darstellung (314, 316, 318, 320) des Audiosignals durch Bereitstellen einer Pegelinformation (314, 316, 318) für Kanalpaare und durch Bereitstellen eines Links/Rechts-Kohärenzmaßes (320) für ein Kanalpaar umfassend einen liken Kanal und einen rechten Kanal als die einzige Kohärenzinformation des Original-Audiosignals innerhalb der parametrischen Darstellung (314, 316, 318, 320), wobei das Links/Rechts-Kohärenzmaß (320) eine Kohärenzinformation zwischen mindestens einem Kanalpaar umfassend einen ersten Kanal mit nur Information von der linken Seite und einen zweiten Kanal mit nur Information von der rechten Seite darstellt; und

Liefern von parametrischer Information für Kanalpaare durch Auswählen von Pegelinformation (314, 316, 318) aus der parametrischen Darstellung (314, 316, 318, 320) und durch Ableiten von Kohärenzinformation für mindestens ein Kanalpaar unter Verwendung des Links/Rechts-Kohärenzmaßes (320), wobei das mindestens eine Kanalpaar einen ersten Kanal (324b, 324d) mit nur Information von der linken Seite und einen zweiten Kanal (324a, 324c) mit nur Information von der rechten Seite umfasst.

27. Codierte Audiodaten mit Seiteninformation, wobei die Seiteninformation eine parametrische Darstellung (314, 316, 318, 320) eines Audiosignals mit mindestens zwei linken Originalkanälen (324b, 324d; 360a, 360b) auf einer linken Seite und zwei rechten Originalkanälen (324a, 324d; 360c, 360d) auf einer rechten Seite in Bezug auf eine Hörposition umfasst, wobei die parametrische Darstellung (314, 316, 318, 320) Pegeldifferenzen (314, 316, 318) für Kanalpaare und ein Links/Rechts-Kohärenzmaß (320) umfasst, das von Kohärenzinformation von einem Kanalpaar umfassend einen ersten Kanal mit nur Information von der linken Seite und einen zweiten Kanal mit nur Information von der rechten Seite abgeleitet ist, als die einzige Kohärenzinformation des Original-Audiosignals innerhalb der parametrischen Darstellung.

28. Computerlesbares Speichermedium, auf dem codierte Audiodaten nach Anspruch 27 gespeichert sind.

29. Empfänger (520) oder Audiospieler mit einem Decodierer (312) nach Anspruch 14.

30. Sender (500) oder Audiorecorder mit einem Codierer (220) nach Anspruch 1.

31. Verfahren zum Empfangen oder zur Audiowiedergabe, wobei das Verfahren ein Verfahren zur Verarbeitung nach Anspruch 26 aufweist.

32. Verfahren zum Senden oder zur Audioaufzeichnung, wobei das Verfahren ein Verfahren zum Erzeugen nach Anspruch 25 aufweist.

33. Sendesystem mit einem Sender (500) und einem Empfänger (520),
wobei der Sender (500) einen Codierer (220) nach Anspruch 1 aufweist, und
wobei der Empfänger (520) einen Decodierer (312) nach Anspruch 14 aufweist.

34. Verfahren zum Senden und Empfangen,
wobei das Verfahren zum Senden ein Verfahren zum Erzeugen nach Anspruch 25 aufweist, und
wobei das Verfahren zum Empfangen ein Verfahren zum Verarbeiten nach Anspruch 26 aufweist.

35. Computer mit Programmcode zum Durchführen, wenn er auf einem Computer ausgeführt wird, eines der Verfahren nach Anspruch 25, 26, 31, 32 oder 34.

**Revendications**

1. Encodeur pour générer une représentation paramétrique (238) d'un signal audio ayant au moins deux canaux gauches d'origine (224a, 224b) sur un côté gauche et deux canaux droits d'origine (224c, 224d) sur une côté droit par rapport à une position d'écoute, comprenant :

   un générateur (220) pour générer des informations paramétriques, le générateur (220) étant opérationnel pour traiter séparément plusieurs paires de canaux pour dériver des informations de niveau (230a, 230b, 234) pour des paires de canaux traitées, et dériver des informations de cohérence (236) pour une paire de canaux incluant un premier canal (228a ; 224a, 224b) n'ayant que des informations provenant du côté gauche et un second canal (228b ; 224c, 224d) n'ayant que des informations provenant du côté droit ; et
   un fournisseur (222) pour fournir la représentation paramétrique (238) en sélectionnant les informations de niveau (230a, 230b, 234) pour des paires de canaux et en déterminant une mesure de cohérence gauche/droite en utilisant les informations de cohérence (236) et introduire la mesure de cohérence gauche/droite dans un flux de données de sortie en tant que seules informations de cohérence du signal audio dans la représentation paramétrique (238).

2. Encodeur selon la revendication 1, dans lequel le générateur (220) est opérationnel
pour traiter (242a) un canal avant gauche lf et un canal arrière gauche lr pour dériver des informations de niveau lf/lr, dans lequel une combinaison du canal avant gauche lf et du canal arrière gauche lr forme un canal maître gauche LM, et pour traiter (242b) un canal avant droit rf et un canal arrière droit rr pour dériver des informations de niveau rf/rr, dans lequel une combinaison du canal avant droit rf et du canal arrière droit rr forme un canal maître droit RM ; et pour traiter (242d) le canal maître gauche LM et le canal maître droit RM pour dériver des informations de niveau lm/rm et dériver des informations de cohérence (236), dans lequel une combinaison du canal maître gauche LM et du canal maître droit RM forme un canal maître stéréo SM.

3.  Encodeur selon la revendication 2, dans lequel le générateur (220) est opérationnel pour traiter (242c) un canal central ce et un canal basse fréquence lo pour dériver des informations de niveau ce/lo, dans lequel une combinaison du canal central ce et du canal basse fréquence lo forme un canal maître central CM.

4.  Encodeur selon la revendication 3, dans lequel le générateur (220) est opérationnel pour traiter (242e) le canal maître stéréo SM et le canal maître central CM pour dériver des informations de niveau sm/cm, dans lequel une combinaison du canal maître stéréo SM et du canal maître central CM forme un canal de mixage réducteur (274) ; et dans lequel le fournisseur (222) est opérationnel pour déterminer la mesure de cohérence gauche/droite en utilisant les informations de cohérence (236) et les informations de niveau sm/cm.

5.  Encodeur selon la revendication 4, dans lequel le fournisseur (222) est opérationnel pour calculer (244) la mesure de cohérence gauche/droite en fonction des informations de niveau sm/cm de telle sorte que, dans un cas où les informations de niveau sm/cm indiquent qu'il y a plus d'énergie dans le canal maître stéréo SM que dans le canal maître central CM, la mesure de cohérence gauche/droite est plus proche des informations de cohérence par comparaison à une situation dans laquelle les informations de niveau sm/cm indiquent qu'il y a plus d'énergie dans le canal maître central CM, auquel cas la mesure de cohérence gauche/droite est plus proche de l'unité.

6.  Encodeur selon la revendication 4, dans lequel le fournisseur (222) est opérationnel pour calculer (244) la mesure de cohérence gauche/droite en fonction des informations de niveau sm/cm, de telle sorte que, dans un cas où les informations de niveau sm/cm indiquent qu'un rapport entre l'énergie dans le canal maître stéréo SM et l'énergie dans le canal maître central CM dépasse une valeur prédéfinie, la mesure de cohérence gauche/droite est établie à des informations de cohérence par comparaison à une situation dans laquelle les informations de niveau sm/cm indiquent que le rapport entre l'énergie dans le canal maître stéréo SM et l'énergie dans le canal maître central CM reste inférieur ou égal à la valeur prédéfinie, auquel cas la mesure de cohérence gauche/droite est établie à l'unité.

7.  Encodeur selon la revendication 1, dans lequel le générateur (220) est opérationnel pour traiter (242a) un canal avant gauche lf et un canal avant droit rf pour dériver des informations de niveau lf/rf et des premières informations de cohérence (302a), dans lequel une combinaison du canal avant gauche lf et du canal avant droit rf forme un canal maître avant FM, et pour traiter (242c) un canal arrière gauche lr et un canal arrière droit rr afin de dériver des informations de niveau lr/rr et de dériver des secondes informations de cohérence (302b), dans lequel une combinaison du canal arrière gauche lr et du canal arrière droit rr forme un canal maître arrière RM, et dans lequel le fournisseur (222) est opérationnel pour déterminer la mesure de cohérence gauche/droite en combinant les premières informations de cohérence (302a) et les secondes informations de cohérence (302b).

8.  Encodeur selon la revendication 7, dans lequel le fournisseur (222) est opérationnel pour déterminer la mesure de cohérence gauche/droite sur la base d'une somme pondérée des première et seconde informations de cohérence (302a, 302b), en utilisant des informations de niveau du canal maître avant FM et des informations de niveau du canal maître arrière RM en tant que poids.

9.  Encodeur selon la revendication 7, dans lequel le générateur (220) est opérationnel pour traiter (242c) un canal central ce et un canal basse fréquence lo pour dériver des informations de niveau ce/lo, dans lequel une combinaison du canal central ce et du canal basse fréquence lo forme un canal maître central CM.

10. Encodeur selon la revendication 9, dans lequel le générateur (220) est opérationnel pour traiter (242d) le canal maître avant FM et le canal maître central CM pour dériver des informations de niveau fm/cm, dans lequel une combinaison du canal maître avant FM et du canal maître central CM forme un canal avant pur PF ; et dans lequel le fournisseur (222) est opérationnel pour déterminer la mesure de cohérence gauche/droite combinant les premières et secondes informations de cohérence (302a, 302b) en utilisant de plus les informations de niveau fm/cm.

11. Encodeur selon la revendication 11, dans lequel le générateur (220) est opérationnel pour traiter (242e) le canal avant pur PF et le canal maître arrière RM pour dériver des informations de niveau pf/rm, dans lequel une combinaison du canal avant pur PF et du canal maître arrière RM forme un canal de mixage réducteur.

12. Encodeur selon la revendication 1, dans lequel le générateur (220) est opérationnel pour traiter les paires de canaux dans des trames temporelles discrètes d'une longueur donnée.

13. Encodeur selon la revendication 1, dans lequel le générateur (220) est opérationnel pour traiter les paires de canaux dans des intervalles de fréquence discrets d'une largeur de bande donnée.

14. Décodeur pour traiter une représentation paramétrique (314, 316, 318, 320) d'un signal audio d'origine, le signal audio d'origine ayant au moins deux canaux gauches d'origine (324b, 324d ; 360a, 360b) sur un côté gauche et au moins deux canaux droits d'origine (324a, 324d ; 360c, 360d) sur un côté droit par rapport à une position d'écoute, comprenant :

    un récepteur (310) pour fournir la représentation paramétrique (314, 316, 318, 320) du signal audio, le récepteur (310) étant opérationnel pour fournir des informations de niveau (314, 316, 318) pour des paires de canaux et pour fournir une mesure de cohérence gauche/droite (320) pour une paire de canaux incluant un canal gauche et un canal droit en tant que seules informations de cohérence du signal audio d'origine dans la représentation paramétrique (314, 316, 318, 320), la mesure de cohérence gauche/droite (320) représentant des informations de cohérence entre au moins une paire de canaux incluant un premier canal n'ayant que des informations provenant du côté gauche et un second canal n'ayant que des informations provenant du côté droit ; et

    un processeur (312) pour distribuer des informations paramétriques pour des paires de canaux, le processeur (312) étant opérationnel pour sélectionner des informations de niveau (314, 316, 318) à partir de la représentation paramétrique (314, 316, 318, 320) et pour dériver des informations de cohérence pour au moins une paire de canaux en utilisant la mesure de cohérence gauche/droite (320), la au moins une paire de canaux incluant un premier canal (324b, 324d) n'ayant que des informations provenant du côté gauche et un second canal (324a, 324c) n'ayant que des informations provenant du côté droit.

15. Décodeur selon la revendication 14, dans lequel le récepteur (310) est opérationnel pour fournir des informations de niveau lf/lr (380a) pour une paire de canaux constituée d'un canal d'origine avant gauche lf et d'un canal d'origine arrière gauche lr, dans lequel une combinaison du canal d'origine avant gauche lf et du canal d'origine arrière gauche lr forme un canal maître gauche LM ;

fournir des informations de niveau rf/rr (380b) pour une paire de canaux constituée d'un canal d'origine avant droit rf et d'un canal d'origine arrière droit rr, dans lequel une combinaison du canal d'origine avant droit rf et du canal d'origine arrière droit rr forme un canal maître droit RM ;

fournir des informations de niveau lm/rm (380d) pour une paire de canaux constituée du canal maître gauche LM et du canal maître droit RM, dans lequel une combinaison du canal maître gauche LM et du canal maître droit RM forme un canal maître stéréo SM ; et

dans lequel le processeur (312) est opérationnel pour fournir (352) des informations de cohérence pour le canal maître gauche LM et le canal maître droit RM en utilisant la mesure de cohérence gauche/droite (320) ;

le décodeur comprenant en outre un mélangeur élévateur, le mélangeur élévateur ayant :

    un premier mélangeur élévateur 1 à 2 (354b) pour la génération du canal maître gauche LM et du canal maître droit RM à partir du canal maître stéréo SM en utilisant les informations de niveau lm/rm (380d) et la mesure de cohérence gauche/droite (320) ;

    un deuxième mélangeur élévateur 1 à 2 (354e) pour la génération du canal d'origine avant gauche lf (360a) et du canal d'origine arrière gauche lr (360b) à partir du canal maître gauche LM en utilisant les informations de niveau lf/lr (380a) et des informations de cohérence prédéfinie ; et

    un troisième mélangeur élévateur 1 à 2 (354d) pour la génération du canal d'origine avant droit rf (360c) et du canal d'origine arrière droit rr (360d) à partir du canal maître droit RM en utilisant les informations de niveau rf/rr (380b) et des informations de cohérence prédéfinie.

16. Décodeur selon la revendication 15, dans lequel le récepteur (310) est opérationnel pour fournir des informations de niveau ce/lo (380c) pour une paire de canaux constituée d'un canal central d'origine ce et d'un canal basse fréquence d'origine lo, dans lequel une combinaison du canal central d'origine ce et du canal basse fréquence d'origine lo forme un canal maître central CM ; et

dans lequel le mélangeur élévateur comprend en outre un quatrième mélangeur élévateur 1 à 2 (354c) pour la génération du canal central d'origine ce (360e) et du canal basse fréquence d'origine lo (360f) à partir du canal maître central CM en utilisant les information de niveau ce/lo (380c) et des informations de cohérence prédéfinie.

**17.** Décodeur selon la revendication 16,
dans lequel le récepteur (310) est opérationnel pour fournir des informations de niveau sm/cm (380e) pour une paire de canaux constituée du canal maître stéréo SM et du canal maître central CM, dans lequel une combinaison du canal maître stéréo SM et du canal maître central CM forme un canal de mixage réducteur ; et
dans lequel le mélangeur élévateur comprend en outre un cinquième mélangeur élévateur 1 à 2 (354a) pour la génération du canal maître stéréo SM et du canal maître central CM à partir du canal de mixage réducteur en utilisant les informations de niveau sm/cm (380e) et des informations de cohérence prédéfinie.

**18.** Décodeur selon la revendication 14, dans lequel le récepteur (310) est opérationnel pour
fournir des informations de niveau lf/rf (410a) pour une paire de canaux constituée d'un canal d'origine avant gauche lf et d'un canal d'origine avant droit rf, dans lequel une combinaison du canal d'origine avant gauche lf et du canal d'origine avant droit rf forme un canal maître avant FM ;
fournir des informations de niveau lr/rr (410c) pour une paire de canaux constituée d'un canal d'origine arrière gauche lr et d'un canal d'origine arrière droit rr, dans lequel une combinaison du canal d'origine arrière gauche lr et du canal d'origine arrière droit rr forme un canal maître arrière RM ; et
dans lequel le processeur (312) est opérationnel pour distribuer des premières informations de cohérence pour le canal d'origine avant gauche lf et le canal d'origine avant droit rf et distribuer des secondes informations de cohérence pour le canal d'origine arrière gauche lr et le canal d'origine arrière droit rr en utilisant la mesure de cohérence gauche/droite (320) ;
le décodeur comprenant en outre un mélangeur élévateur, le mélangeur élévateur ayant :

  un premier mélangeur élévateur 1 à 2 (354e) pour la génération du canal d'origine avant gauche lf (360a) et du canal d'origine avant droit rf (360c) à partir du canal maître avant FM en utilisant les informations de niveau lf/rf (410a) et la mesure de cohérence gauche/droite (320) ;
  un deuxième mélangeur élévateur 1 à 2 (354c) pour la génération du canal d'origine arrière gauche lr (360b) et du canal d'origine arrière droit rr (360d) à partir du canal maître arrière RM en utilisant les informations de niveau lr/rr (410c) et la mesure de cohérence gauche/droite (320).

**19.** Décodeur selon la revendication 18,
dans lequel le récepteur (310) est opérationnel pour fournir des informations de niveau ce/lo (410b) pour une paire de canaux constituée d'un canal central d'origine ce et d'un canal basse fréquence d'origine lo, dans lequel une combinaison du canal central d'origine ce et du canal basse fréquence d'origine lo forme un canal maître central CM ; et
dans lequel le mélangeur élévateur comprend en outre un troisième mélangeur élévateur 1 à 2 (354d) pour la génération du canal central d'origine co (360e) et du canal basse fréquence d'origine lo (360f) à partir du canal maître central CM en utilisant les informations de niveau ce/lo (410b) et des informations de cohérence prédéfinie.

**20.** Décodeur selon la revendication 19,
dans lequel le récepteur (310) est opérationnel pour fournir des informations de niveau fm/cm (410b) pour une paire de canaux constituée du canal maître avant FM et du canal maître central CM, dans lequel une combinaison du canal maître avant FM et du canal maître central CM forme un canal avant pur PF ; et
dans lequel le mélangeur élévateur comprend en outre un quatrième mélangeur élévateur 1 à 2 (354b) pour la génération du canal maître avant FM et du canal maître central CM à partir du canal avant pur PF en utilisant les informations de niveau fm/cm (410b) et des informations de cohérence prédéfinie.

**21.** Décodeur selon la revendication 20,
dans lequel le récepteur (310) est opérationnel pour fournir des informations de niveau pf/rm (410a) pour une paire de canaux constituée du canal avant pur PF et du canal maître arrière RM, dans lequel une combinaison du canal avant pur PF et du canal maître arrière RM forme un canal de mixage réducteur ; et
dans lequel le mélangeur élévateur comprend en outre un cinquième mélangeur élévateur 1 à 2 (354a) pour la génération du canal avant pur PF et du canal maître arrière RM à partir du canal de mixage réducteur en utilisant les informations de niveau pf/rm (410a) et des informations de cohérence prédéfinie.

**22.** Décodeur selon la revendication 14, dans lequel le processeur (312) est opérationnel pour dériver des mesures de cohérence pour toutes les paires de canaux en distribuant la mesure de cohérence gauche/droite reçue (320) en tant que mesures de cohérence.

**23.** Décodeur selon la revendication 14, dans lequel le récepteur (310) est opérationnel pour
fonctionner dans un premier mode, fournissant des informations de niveau (314, 316, 318) pour des paires de canaux et fournissant une mesure de cohérence gauche/droite (320) pour une paire de canaux incluant un canal gauche et un canal droit en tant que seules informations de cohérence du signal audio dans la représentation paramétrique (314, 316, 318, 320), la mesure de cohérence gauche/droite (320) représentant des informations de cohérence entre au moins une paire de canaux incluant un premier canal n'ayant que des informations provenant du côté gauche et un second canal n'ayant que des informations provenant du côté droit par rapport à une position d'écoute ; ou

fonctionner dans un second mode, fournissant les informations de niveau (314, 316, 318) pour des paires de canaux et les informations de cohérence pour les mêmes paires de canaux ; et

dans lequel le processeur (312) est opérationnel pour distribuer des informations paramétriques pour des paires de canaux

dans le premier mode, le processeur (312) étant opérationnel pour sélectionner les informations de niveau (314, 316, 318) à partir de la représentation paramétrique (314, 316, 318, 320) et pour dériver les informations de cohérence pour au moins une paire de canaux en utilisant la mesure de cohérence gauche/droite (320), la au moins une paire de canaux incluant un premier canal n'ayant que des informations provenant du côté gauche et un second canal n'ayant que des informations provenant du côté droit ; ou

dans le second mode, le processeur (312) étant opérationnel pour sélectionner les informations de niveau (314, 316, 318) à partir de la représentation paramétrique (314, 316, 318, 320) et sélectionner les informations de cohérence à partir de la représentation paramétrique (314, 316, 318, 320).

24. Décodeur selon la revendication 23, dans lequel le récepteur (310) comprend en outre un récepteur de mode pour sélectionner un mode de fonctionnement en utilisant des informations de mode reçues, les informations de mode indiquant le premier ou le second mode à utiliser.

25. Procédé pour générer une représentation paramétrique (238) d'un signal audio ayant au moins deux canaux gauches d'origine (224a, 224b) et au moins deux canaux droits d'origine (224c, 224d) par rapport à une position d'écoute, le procédé comprenant de :

    générer des informations paramétriques en traitant séparément plusieurs paires de canaux afin de dériver des informations de niveau (230a, 230b, 234) pour des paires de canaux traitées et en dérivant des informations de cohérence (236) pour une paire de canaux incluant un premier canal (228a ; 224a, 224b) n'ayant que des informations provenant du côté gauche et un second canal (228b ; 224c, 224d) n'ayant que des informations provenant du côté droit, et
    fournir la représentation paramétrique (238) en sélectionnant des informations de niveau (230a, 230b, 234) pour des paires de déplacements et en déterminant une mesure de cohérence gauche/droite en utilisant les informations de cohérence (236) et en introduisant la mesure de cohérence gauche/droite dans un flux de données de sortie en tant que seules informations de cohérence (236) du signal audio dans la représentation paramétrique (238).

26. Procédé de traitement d'une représentation paramétrique (314, 316, 318, 320) d'un signal audio d'origine, le signal audio d'origine comportant au moins deux canaux gauches d'origine (324b, 324d ; 360a, 360b) sur le côté gauche et au moins deux canaux droits d'origine (324a, 324d ; 360c, 360d) sur le côté droit par rapport à une position d'écoute, le procédé comprenant de :

    fournir la représentation paramétrique (314, 316, 318, 320) du signal audio en fournissant des informations de niveau (314, 316, 318) pour des paires de canaux et en fournissant une mesure de cohérence gauche/droite (320) pour une paire de canaux incluant un canal gauche et un canal droit en tant que seules informations de cohérence du signal audio d'origine dans la représentation paramétrique (314, 316, 318, 320), la mesure de cohérence gauche/droite (320) représentant des informations de cohérence entre au moins une paire de canaux incluant un premier canal n'ayant que des informations provenant du côté gauche et un second canal n'ayant que des informations provenant du côté droit ; et
    distribuer des informations paramétriques pour des paires de canaux en sélectionnant des informations de niveau (314, 316, 318) à partir de la représentation paramétrique (314, 316, 318, 320) et en dérivant des informations de cohérence pour au moins une paire de canaux en utilisant la mesure de cohérence gauche/droite (320), la au moins une paire de canaux incluant un premier canal (324b, 324d) n'ayant que des informations provenant du côté gauche et un second canal (324a, 324c) n'ayant que des informations provenant du côté droit.

27. Données audio codées avec des informations secondaires, les informations secondaires comprenant une représentation paramétrique (314, 316, 318, 320) d'un signal audio ayant au moins deux canaux gauches d'origine (324b, 324d ; 360a, 360b) sur un côté gauche et deux canaux droits d'origine (324a, 324d ; 360c, 360d) sur un côté droit par rapport à une position d'écoute, la représentation paramétrique (314, 316, 318, 320) comprenant des différences de niveau (314, 316, 318) pour des paires de canaux et une mesure de cohérence gauche/droite (320) dérivée d'informations de cohérence provenant d'une paire de canaux incluant un premier canal n'ayant que des informations provenant du côté gauche et un second canal n'ayant que des informations provenant du côté droit, en tant que seules informations de cohérence du signal audio d'origine dans la représentation paramétrique.

28. Support de stockage lisible par ordinateur, sur lequel sont stockées des données audio codées selon la revendication 27.

29. Récepteur (520) ou lecteur audio ayant un décodeur (312) selon la revendication 14.

30. Émetteur (500) ou enregistreur audio ayant un encodeur (220) selon la revendication 1.

31. Procédé de réception ou de lecture audio, le procédé ayant un procédé de traitement selon la revendication 26.

32. Procédé de transmission ou d'enregistrement audio, le procédé ayant un procédé de génération selon la revendication 25.

33. Système de transmission ayant un émetteur (500) et un récepteur (520), dans lequel l'émetteur (500) a un encodeur (220) selon la revendication 1, et dans lequel le récepteur (520) a un décodeur (312) selon la revendication 14.

34. Procédé de transmission et de réception,
dans lequel le procédé de transmission a un procédé de génération selon la revendication 25, et
dans lequel le procédé de réception a un procédé de traitement selon la revendication 26.

35. Ordinateur ayant un code de programme pour effectuer, lorsqu'il est exécuté sur un ordinateur, l'un quelconque des procédés selon les revendications 25, 26, 31, 32, ou 34.

Fig. 1

Fig. 2

Fig. 2a

Fig. 3a

Fig. 3b

Fig. 4

EP 1 869 667 B1

Fig. 5

Fig. 6

EP 1 869 667 B1

34

Fig. 7

500

502

Multi
channel
signal

Transmit/
Store

504

220

Fig. 8

520

522

Recieve
Read →

Playback/
output

524

312

Fig. 9

Multi
channel
signal →

500

502

522

520

Playback/
output →

504

524

Fig. 10

Fig. 11
(Prior Art)

BCC ENCODER — 112    115 — BCC DECODER    120  124

DOWNMIX Σ    SUM SIGNAL    BBC SYNTHESIS

114    122

110    SIDE INFO    121

BCC ANALYSIS    SIDE INFO PROCESSING

ICLD, ICTD, ICC

117

116    123

Fig. 12
(Prior Art)

Fig. 13

(Prior Art)

Fig. 14
(Prior Art)

Fig. 15
(Prior Art)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 0219130 A1
- US 20030026441 A1
- US 20030035553 A1
- WO 2004008805 A1
- US 11032689 B
- US 20030219130 A1

**Non-patent literature cited in the description**

- **J. BREEBAART ; S. VAN DE PAR ; A. KOHLRAUSCH ; E. SCHUIJERS.** High-Quality Parametric Spatial Audio Coding at Low Bitrates. *AES 116th Convention,* May 2004
- **E. SCHUIJERS ; J. BREEBAART ; H. PURNHAGEN ; J. ENGDEGARD.** Low Complexity Parametric Stereo Coding. *AES 116th Convention,* May 2004
- **C. FALLER ; F. BAUMGARTE.** Binaural Cue Coding applied to Stereo and Multi-Channel Audio Compression. *the AES convention paper 5574,* May 2002
- Efficient representation of spatial audio using perceptual parametrization. *the IEEE WASPAA Paper,* October 2001
- **C. FALLER, F. BAUMGARTE.** Estimation of auditory spatial cues for binaural cue coding. *2 ICASSP Papers,* May 2002
- **C. FALLER ; F. BAUMGARTE.** *Binaural cue coding: a novel and efficient representation of spatial audio,* May 2002
- **C. FALLER ; F. BAUMGARTE.** Binaural Cue Coding. Part II: Schemes and Applications. *IEEE Trans. on Audio and Speech Proc.,* November 2003, vol. 11 (6
- **C. FALLER ; F. BAUMGARTE.** Binaural cue coding applied to audio compression with flexible rendering. *AES 113th Convention,* October 2002
- **J. BREEBAART ; S. VAN DE PAR ; A. KOHLRAUSCH ; E. SCHUIJERS.** Parametric coding of stereo audio. *Eurasip J. Applied Signal Proc.,* 2005, vol. 9, 1305-1322